# EUROPEAN PATENT APPLICATION

(11) **EP 1 613 132 A1**
(43) Date of publication of application: **04.01.2006**
(21) Application number: 04715509.8
(22) Date of filing: 27.02.2004
(51) Int. Cl.: H05B 33/14, H05B 33/22

(54) **ORGANIC ELECTROLUMINESCENT DEVICE**

(30) Priority: 27.02.2003 JP 2003050570; 12.05.2003 JP 2003132459
(71) Applicant: KABUSHIKI KAISHA TOYOTA JIDOSHOKKI, Kariya-shi, Aichi 448-8671 (JP)
(72) Inventor: NAGARA, Yoshiaki, c/o K. K. Toyota Jidoshokki, Kariya-shi, Aichi 4488671 (JP); MURASAKI, Takanori, c/o K. K. Toyota Jioshokki, Kariya-shi, Aichi 448-8671 (JP); MORI, Kenji, C/o Kabushiki K. Toyota Jidoshokki, Kariya-shi, Aichi 4488671 (JP); YAMAMOTO, Ichiro, c/o K. K. Toyota Jidoshokki, Kariya-shi, Aichi 4488671 (JP); KATO, Yoshifumi, c/o K. K. Toyota Jidoshokki, Kariya-shi, Aichi 4488671 (JP); KAWASAKI, Shintaro, c/o K. K. Toyota Jidoshokki, Kariya-shi, Aichi 448-8671 (JP); TAKEUCHI, Kazuyoshi, c/o K. K. Toyota Jidoshokki, Kariya-shi, Aichi 448-8671 (JP)
(74) Representative: TBK-Patent
(86) International application number: PCT/JP2004/002330
(87) International publication number: WO 2004/077886

(57) **Abstract**

The present invention provides organic EL devices which have on their anode at least a light-emitting layer, an electron-injecting-transporting layer, and a cathode giving an elongated lifetime, organic EL devices giving a superior whiteness, a higher light-emitting efficiency, and an elongated lifetime compared to conventional ones, and color displays using such organic EL devices.

On anode (10), hole-injecting-transporting layer (11), light-emitting layer (12), non-light-emitting layer (13), electron-injecting-transporting layer (14), and cathode (15) in this order are laminated. Otherwise, on an anode, a hole-injecting layer, a hole-transporting layer, a red light-emitting layer, a blue light-emitting layer, an electron-transporting layer, an electron-injecting layer, and a cathode in this order are laminated.

## Description

### TECHNICAL FIELD

The present invention relates to organic electro-luminescence (EL) devices having on their anode at least a light-emitting layer, an electron-injecting-transporting layer, and a cathode. The present invention relates also to organic EL devices having on their anode at least an organic light-emitting layer and then a cathode in this order.

### BACKGROUND ART

Conventionally, organic EL devices have been known which have a light-emitting layer(s), containing an organic light-emitting material, between an electrode and a counter electrode, said light-emitting layer(s) generating electro-luminescence (EL) by current between these electrodes. The following functions are required in said light-emitting layer(s).
i) an electron-injecting function
   A function for receiving electrons injected from an electrode, that is, a cathode. An electron-injecting property.
ii) a hole-injecting function
   A function for receiving holes injected from an electrode, that is, an anode. A hole-injecting property.
iii) a carrier-transporting function
   A function for transporting at least one of electrons or holes. A carrier-transporting property.
   A function for transporting electrons is called "electron-transporting function" or "electron-transporting property". A function for transporting holes is called "hole-transporting function" or "hole-transporting property".
iv) a light-emitting function
   a function for generating excitons by re-combination of electrons and holes injected and transported and then for generating luminescence upon return to the base state.

Conventional technologies have also been known which laminate another layer having one or more of the above functions besides light-emitting layers. For example, a conventional technology has also been known which laminates another layer, having electron-injecting and electron-transporting functions, that is "electron-injecting-transporting layer". See for example JP2002-164174A. Such a lamination of "electron-injecting-transporting layer" besides light-emitting layers or such a separation of functions can generally achieve the following effects.
i) a lower driving-voltage;
ii) stabilized injection of electrons from a cathode to a light-emitting layer and the resulting longer lifetime;
iii) improved adhesion between a cathode and a light-emitting layer and the resulting more highly uniform light-emitting surfaces; and
iv) coating projections on a cathode and decreasing defects as a whole device.

Further, recently, one of great expectations to organic EL devices is their application to full-colored display devices. One of methods for full-colored displaying using organic EL devices has been known, in which method white lights emitted from organic EL devices are separated by color filters into red, green, and blue lights. The organic EL devices used here are required to have the following properties:
i) a good balance amongst light-emitting intensities of red, green, and blue;
ii) a high light-emitting efficiency; and
iii) a long lifetime.

As an organic EL device of a relatively good balance amongst light-emitting intensities of red, green, and blue, an organic EL device has been known which has from its anode side a blue light-emitting layer and a green light-emitting layer in this order laminated as organic light-emitting layers, said green light-emitting layer containing a red light-emitting dopant. For example, see Japanese Patent Laid-open N° 7-142 169.

### DISCLOSURE OF THE INVENTION

However, even the above mentioned organic EL devices comprising layers having electron-injecting and electron-transporting functions other than light-emitting layers are difficult to obtain a sufficient lifetime in practice.

Further, there was also a problem that conventional organic EL devices emitting white lights were poor at their whiteness, low in their light-emitting efficiency, and short in their lifetime.

The present invention has been made considering the above mentioned problems. An object of the present invention is to elongate lifetime of organic EL devices having at least a light-emitting layer, an electron-injecting-transporting layer, and a cathode on an anode compared to conventional ones.

Considering the above mentioned problems, another object of the present invention is to improve whiteness, light-emitting efficiency, and lifetime of organic EL devices having at least an organic light-emitting layer and then a cathode in this order on an anode compared to conventional ones.

In order to achieve the above objects, the present organic EL devices of the present invention are characterized in that they have on their anode a light-emitting layer, an electron-injecting-transporting layer, and a cathode and have a non-light-emitting layer between said electron-injecting-transporting layer and said light-emitting layer, said non-light-emitting layer, that is a non-light-emitting carrier balance-adjusting layer, having an electron-transporting property and having a higher hole-transporting property than said electron-injecting-transporting layer has. Said electron-injecting-transporting layer may consist of a single layer or of laminated layers. For example, said electron-injecting-transporting layer may consist of an electron-injecting layer and an electron-transporting layer.

Electron- and hole-transporting properties can be known to be high or low for example by Time of Flight (TOF) method, where a pulsed light is radiated onto a sample surface to which a voltage is applied. Based upon transient current generated upon movements of carriers generated by the pulsed light within the sample layer, the voltage applied to the sample, and upon the thickness of the sample, mobility of the carriers can be calculated in cm²/V.s. In particular, a film of a single layer, for example of around 10-20 µm thickness, whose electron/hole-transporting properties are to be measured is prepared. Using the film, mobility of the carriers is measured. Electron/hole-transporting properties of each material were evaluated by carrier-mobility measured using a prepared layer containing only the material, for example, of around 10-20 µm film thickness. Further, provided that electric field intensity applied upon measuring the carrier-mobility be within the range of that applied upon actual use of organic EL devices.

Accordingly, the above organic EL devices include also those having on their anode a light-emitting layer, an electron-injecting-transporting layer, and a cathode and having a non-light-emitting layer laminated between said electron-injecting-transporting layer and said light-emitting layer, said non-light-emitting layer having electron- and hole-transporting properties, wherein the hole-mobility of said non-light-emitting layer is greater than that of said electron-injecting-transporting layer as specified by TOF method.

"Having an electron-transporting property" herein refers to at least having a higher electron-transporting property than materials/layers on the anode side relatively to light-emitting layers have, preferably referring to a higher electron-transporting property than that of the light-emitting layers, and naturally referring to an electron-transporting property equal to/higher than that of the electron-injecting-transporting layer.

The non-light-emitting layer of the above organic EL devices is better to have a higher, stronger, or greater electron-transporting property rather than the hole-transporting property For example, it is preferable in the non-light-emitting layer that the electron-mobility specified by TOF method should be greater than the hole-mobility specified by TOF method.

Further, the non-light-emitting layer of the first or second present organic EL devices is better to contain the following material (i) or (ii).
(i) a material having an electron-transporting property and having a higher hole-transporting property than the electron-injecting-transporting layer has.
   Including, for example, materials having both an electron-transporting property and a hole-transporting property and having a hole-mobility greater than that of the electron-injecting-transporting layer as specified by TOF method.
(ii) one or more electron-transporting material(s) having an electron-transporting property and one or more hole-transporting material(s) having a higher hole-transporting property than the electron-injecting-transporting layer has.
   Said hole-transporting material(s) including, for example, one or more material(s) having a hole-mobility greater than the electron-mobility of said electron-transporting material(s) as specified by TOF method.

In above (ii), at least one of the electron-transporting materials may be the same as at least one of the materials contained in the electron-injecting-transporting layer. Further, at least one of the hole-transporting materials may be the same as at least one of the materials contained in the light-emitting layers.

Also in above (ii), it is better that the electron-transporting property of the electron-transporting material is higher than the hole-transporting property of the hole-transporting material. For example, it is better that the electron-mobility of the electron-transporting material is greater than the hole-mobility of the hole-transporting material as specified by TOF method.

Further, the present organic EL devices are especially preferable where their light-emitting layer(s) has/have a hole-transporting property, that is, where the hole-transporting property is higher than the electron-transporting property.

"Bipolar material" herein is defined to be a material whose hole-mobility and electron-mobility are 10⁻⁸ cm²/V.s or greater within the range of electric field intensity applied upon actual use of the present organic EL device.

The present organic EL devices are characterized in that they have on their anode at least an organic light-emitting layer and then a cathode in this order, said organic light-emitting layer consisting of a red light-emitting layer and then a blue light-emitting layer in this order from the anode side, and said red light-emitting layer containing a green light-emitting dopant.

The spectrum of the light emitted from the above organic EL device preferably has local maximum points in ranges of 440 nm-490 nm, 510 nm-550 nm, and of 580 nm-680 nm.

A emission-adjusting layer may be laminated between the red light-emitting layer and the blue light-emitting layer thereby further improving whiteness, light-emitting efficiency, and lifetime. Further, it is preferable for the blue light-emitting layer to be thicker than the red light-emitting layer. "Emission-adjusting layer" here means a layer to adjust the ratio of light-emitting intensities of light-emitting materials.

The red light-emitting layer preferably contains at least one red light-emitting dopant(s).

The hole-mobility of the red light-emitting layer is desirably greater than that of the blue light-emitting layer.

The present color displays are characterized in that they have the present organic EL device and at least one kind(s) of filter(s) absorbing part of spectrum of the light emitted from the present organic EL device. Its light-emitting region is preferably within the transmission region of the filter(s).

According to the present invention, lifetime of organic EL devices having a light-emitting layer, an electron-injecting-transporting layer, and a cathode on an anode can be longer than that of conventional ones not using the present construction.

According to the present invention, whiteness, light-emitting efficiency, and lifetime of organic EL devices having at least an organic light-emitting layer and then a cathode in this order on an anode can be improved compared to conventional ones not using the present construction.

### BRIEF DESCRIPTION OF THE DRAWINGS

Figure 1 (Fig. 1) is a cross sectional figure to set forth a layer construction example of the present organic EL device according to the first embodiment.
Figure 2 (Fig. 2) is a cross sectional figure to set forth a modified layer construction example of the present organic EL device according to the first embodiment.
Figure 3 (Fig. 3) is a cross sectional figure to illustrate a modified layer construction example of the present organic EL device according to the first embodiment.
Figure 4 (Fig. 4) is a cross sectional figure to illustrate a modified layer construction example of the present organic EL device according to the first embodiment.
Figure 5 (Fig. 5) is a cross sectional figure to set forth a layer construction example of the present organic EL device according to the second embodiment.
Figure 6 (Fig. 6) is an outlined figure of the whole construction of the present color display
Figure 7 (Fig. 7) is a model cross sectional figure of the organic EL panel used in the color display of Fig. 6.

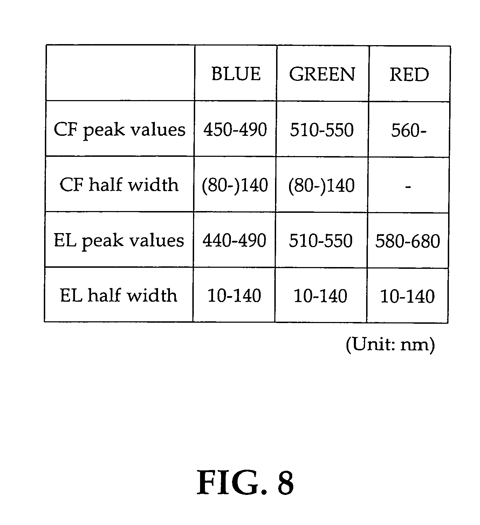

Figure 8 (Fig. 8) is a table showing transmission peak wave lengths and their half widths of the color filters used in the color display of Fig. 6 and showing emission peak wave lengths and their half widths of the present organic EL device.

### BEST MODE FOR CARRYING OUT THE INVENTION

Hereinafter the present organic EL device according to embodiments of the present invention will be set forth in detail with reference to the figures.

### The first embodiment

### << Layer constructions >>

The present organic EL devices according to the first embodiment have constructions where at least a light-emitting layer, a non-light-emitting layer, an electron-injecting-transporting layer, and then a cathode in this order are formed on an anode. The present organic EL devices according to the first embodiment are characterized in that the non-light-emitting layer of the present invention is laminated between the light-emitting layer and the electron-injecting-transporting layer.

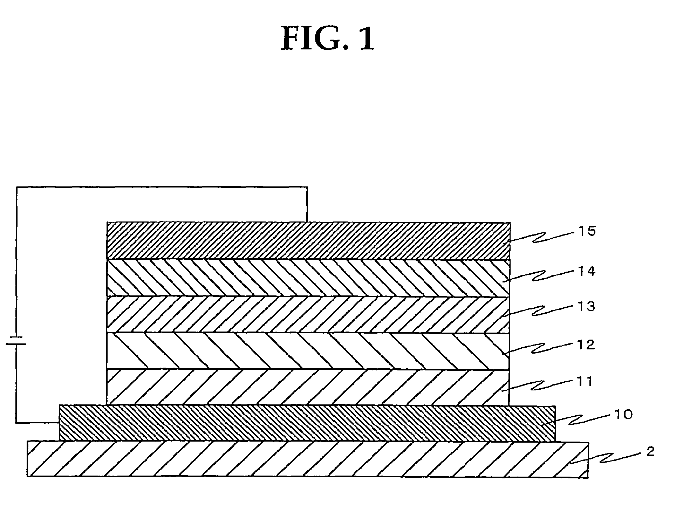

In the followings, the present organic EL device illustrated in Fig. 1, where anode (10) is formed on substrate (2) and where on anode (10) thus formed, hole-injecting-transporting layer (11), light-emitting layer (12), non-light-emitting layer (13), electron-injecting-transporting layer (14), and then cathode (15) in this order are formed, will mainly be set forth, but naturally, other layer constructions can also be used.

For example, the light-emitting layer can have also functions of the hole-injecting-transporting layer, which are a hole-injecting function and a hole-transporting function, and the hole-injecting-transporting layer can then be omitted. It is also possible that in view of functions the electron-injecting-transporting layer is divided into an electron-injecting layer having an electron-injecting function and an electron-transporting layer having an electron-transporting function and then laminated. In particular, the following layer constructions can also be used.
i) an anode/a hole-injecting layer/a hole-transporting layer/a light-emitting layer/a non-light-emitting layer/an electron-transporting layer/an electron-injecting layer/a cathode
ii) an anode/a hole-injecting layer/a hole-transporting layer/a light-emitting layer/a non-light-emitting layer/an electron-injecting-transporting layer/a cathode
iii) an anode/a hole-injecting-transporting layer/a light-emitting layer/a non-light-emitting layer/an electron-transporting layer/an electron-injecting layer/a cathode
iv) an anode/a hole-injecting-transporting layer/a light-emitting layer/a non-light-emitting layer/an electron-injecting-transporting layer/a cathode
v) an anode/a hole-transporting layer/a light-emitting layer/a non-light-emitting layer/an electron-transporting layer/an electron-injecting layer/a cathode
vi) an anode/a hole-transporting layer/a light-emitting layer/a non-light-emitting layer/an electron-injecting-transporting layer/a cathode
vii) an anode/a light-emitting layer/a non-light-emitting layer/an electron-transporting layer/an electron-injecting layer/a cathode
viii) an anode/a light-emitting layer/a non-light-emitting layer/an electron-injecting-transporting layer/a cathode

All the above layers may have functions other than those mentioned above. For example, the light-emitting layer may have hole-transporting, hole-injecting, electron-injecting, and/or electron-transporting function(s).

Further, layers other than those mentioned above can suitably be laminated.

Naturally, the present organic EL devices can be formed also by lamination in the reverse order from the cathode on the substrate.

Layers between the non-light-emitting layer and the cathode are herein combined and called "electron-injecting-transporting layer".

Firstly, the non-light-emitting layer will be set forth in detail.

### << Non-light-emitting layer (13) >>

Non-light-emitting layer (13) is laminated between electron-injecting-transporting layer (14) and light-emitting layer (12) and has an electron-transporting property and a higher hole-transporting property than electron-injecting-transporting layer (14) has, but does not have a light-emitting function.

Electron-transporting and hole-transporting properties can be specified for example by TOF method. Thus, non-light-emitting layer (13) can also be as follows.
i) Hole-mobility as measured by TOF method is greater than that, as specified by TOF method, of electron-injecting-transporting layer (14).
ii) A layer to adjust balance of carriers, which are holes and electrons, in light-emitting layer (12). A carrier balance-adjusting layer.
iii) A layer not having a light-emitting function.

### < Mechanism >

The present organic EL devices according to the first embodiment have a longer lifetime than conventional ones due to non-light-emitting layer (13) as mentioned above. This mechanism can be estimated as shown below in < Mechanism 1 > and < Mechanism 2 >.

### < Mechanism 1 >

One can also think that since holes and excitons are more difficult to enter electron-injecting-transporting layer (14), damages in electron-injecting-transporting layer (14) are less than those in conventional cases, resulting in elongated lifetime.

In conventional organic EL devices, part of holes injected and transported from the anode side into a light-emitting layer did not re-combine with electrons in the light-emitting layer and entered the electron-injecting-transporting layer. On the other hand, electron-injecting-transporting materials contained in the electron-injecting-transporting layer have a very poor hole-transporting property and thus have a poor resistance against holes. Accordingly, when holes enter the electron-injecting-transporting layer, it or its electron-injecting-transporting materials seem to have become deteriorated.

Also in conventional organic EL devices, excitons generated by re-combination of holes entered with electrons injected and transported from the cathode side and excitons entered from the light-emitting layer side seem to have made the electron-injecting-transporting layer or its electron-injecting-transporting materials deteriorated.

By contrast, since non-light-emitting layer (13) in the first embodiment of the present invention has a higher hole-transporting property than electron-injecting-transporting layer (14) has, non-light-emitting layer (13) has a stronger resistance against holes entered and excitons than electron-injecting-transporting layer (14) has.

Further, since non-light-emitting layer (13) has an electron-transporting property, non-light-emitting layer (13) can transport electrons transported from electron-injecting-transporting layer (14) to light-emitting layer (12). In deed, since most of holes and electrons re-combine in light-emitting layer (12) or in non-light-emitting layer (13), there are fewer re-combinations in electron-injecting-transporting layer (14) and fewer entries of holes into electron-injecting-transporting layer (14) than those in conventional devices not having non-light-emitting layer (13).

Thus, it is difficult for holes and excitons to enter electron-injecting-transporting layer (14) which can be heavily damaged by them. Further, resistance of non-light-emitting layer (13) against holes and excitons is stronger than that of electron-injecting-transporting layer (14), resulting in fewer damages of non-light-emitting layer (13) and of electron-injecting-transporting layer (14) than of the electron-injecting-transporting layer of conventional devices. Accordingly, the present organic EL devices according to the first embodiment seem to come to have a longer lifetime.

### < Mechanism 2 >

Since non-light-emitting layer (13) has a hole-transporting property and an electron-transporting property, fewer excitons and a lower possibility of their existence are at the interface of electron-injecting-transporting layer (14), which interface is the opposite one to cathode (15), hereinafter suitably called "the interface of electron-injecting-transporting layer (14)", resulting in fewer damages in electron-injecting-transporting layer (14) than those in conventional cases. Accordingly, one can also think that lifetime can have been longer than that in conventional cases.

Conventionally, it has been known that when the interface and its vicinity of an electron-injecting-transporting layer have many excitons, it is facile to become deteriorated.

On the other hand, as noted above, since the electron-injecting-transporting layer has little hole-transporting property, many holes transported from a light-emitting layer side to the electron-injecting-transporting layer side exist at the interface and its vicinity of the electron-injecting-transporting layer. Accordingly, with these holes, electrons injected and transported from the cathode side re-combine generating excitons at the interface and its vicinity of the electron-injecting-transporting layer.

Accordingly, in conventional organic EL devices, since many excitons are likely to be at the interface and its vicinity of the electron-injecting-transporting layer, it readily becomes deteriorated resulting in difficulty to obtain sufficient lifetime.

By contrast, since non-light-emitting layer (13) according to the first embodiment of the present invention has a higher hole-transporting property than electron-injecting-transporting layer (14) has, non-light-emitting layer (13) can transport holes from the interface and its vicinity between non-light-emitting layer (13) and light-emitting layer (12) to electron-injecting-transporting layer (14). Since non-light-emitting layer (13) has also an electron-transporting property, non-light-emitting layer (13) can transport electrons transported from electron-injecting-transporting layer (14) to light-emitting layer (12) with giving excitons by re-combination of holes being transferred within non-light-emitting layer (13) with electrons within it. The amounts of excitons at the interface and its vicinity between electron-injecting-transporting layer (14) and non-light-emitting layer (13) can be made fewer than the amounts of excitons at the interface and its vicinity between the electron-injecting-transporting layer and the light-emitting layer of conventional organic EL devices not having non-light-emitting layer (13). Thus, it seems that the present organic EL devices according to the first embodiment receive fewer damages in electron-injecting-transporting layer (14) than conventional organic EL devices receive, resulting in a longer lifetime than that of conventional organic EL devices.

Further, based upon the above mechanisms, non-light-emitting layer (13) can be considered to be better when its electron-transporting property is higher than its hole-transporting property, for example, when its electron-mobility as specified by TOF method is greater than its hole-mobility as specified by TOF method.

Thus constructed, in non-light-emitting layer (13), the amount/speed of transfer of electrons transported from electron-injecting-transporting layer (14) to light-emitting layer (12) can be greater than the amount/speed of transferring holes entered from light-emitting layer (12) to electron-injecting-transporting layer (14). Accordingly, further fewer holes and excitons enter electron-injecting-transporting layer (14) and further fewer holes and a further lower existence possibility of holes are at the interface and its vicinity of electron-injecting-transporting layer (14) thereby giving fewer damages of electron-injecting-transporting layer (14) and giving a further longer lifetime of the present organic EL devices.

Thus, a higher electron-mobility of non-light-emitting layer (13) allows light-emitting efficiency to be further improved.

Further, if constructed as noted above, light-emitting efficiency can also be higher since possibility of re-combination of holes with electrons in light-emitting layer (12) can be higher than that of conventional cases.

Non-light-emitting layer (13) can be formed with a single material or with a plurality of materials. Hereinafter, materials to be contained in non-light-emitting layer (13) and its preparing method will be set forth.

### < In cases of a single material used>

When non-light-emitting layer (13) is made of a single material, a material is used which gives non-light-emitting layer (13) an electron-transporting property and a higher hole-transporting property than that of electron-injecting-transporting layer (14) or its material. Such a material is for example that having an electron-transporting property and having a hole-mobility greater than that of electron-injecting-transporting layer (14) as specified by TOF method. In particular, the following materials can be selected:
distyrylarylene derivatives, distyrylbenzene derivatives, distyrylamine derivatives, metal-quinolinolate complexes, triarylamine derivatives, azomethyne derivatives, oxadiazole derivatives, pyrazoloquinoline derivatives, silole derivatives, dicarbazole derivatives, oligothiophene derivatives, tetraphenyl butadiene derivatives, benzopyran derivatives, triazole derivatives, benzoxazole derivatives, benzothiazole derivatives, aluminum tris(8-quinolinolate), *N*,*N*'-bis(4'-diphenylamino-4-biphenylyl)-*N*,*N'*-diphenylbenzidine, 4,4'-bis(2,2'-diphenylvinyl)biphenyl, etc.

Amongst such materials, those without luminescence upon formation of non-light-emitting layer (13) are preferably selected. This reason why is because chromaticity etc. of emitted lights from light-emitting layer (12) would be damaged if non-light-emitting layer (13) emitted a light.

### < In cases of a plurality of materials used >

When non-light-emitting layer (13) is made of a plurality of materials, at least one or more electron-transporting material(s) having an electron-transporting property and one or more hole-transporting material(s) having a higher hole-transporting property than electron-injecting-transporting layer (14) has are selected. The hole-transporting material may be that having a hole-mobility greater than that of the electron-transporting material contained in non-light-emitting layer (13) as determined by TOF method.

It is better that the electron-transporting property of the electron-transporting material is allowed to be stronger than the hole-transporting property of the hole-transporting material. For example, if the materials are selected so that the electron-mobility of the electron-transporting material is greater than the hole-mobility of the hole-transporting material as specified by TOF method, the electron-mobility is greater than the hole-mobility in non-light-emitting layer (13) to obtain the above mentioned effects.

The electron-transporting materials may be those having the above mentioned properties. For example, the following materials can also be selected:
oxadiazole derivatives such as 1,3-bis[5'-(*p*-*tert*-butylphenyl)-1,3,4-oxadiazol-2'-yl]benzene and 2-(4-biphenylyl)-5-(4-*tert-*-butylphenyl)-1,3,4-oxadiazole;
triazole derivatives such as 3-(4'-*tert*-butylphenyl)-4-phenyl-5-(4"-biphenyl)-1,2,4-triazole;
triazine derivatives; perylene derivatives; quinoline derivatives;
quinoxaline derivatives; diphenylquinone derivatives;
nitro-substituted fluorenone derivatives; anthraquinodimethane derivatives; thiopyran dioxide derivatives; heterocyclic tetracarboxylic acid anhydrides such as naphthaleneperylene, carbodiimide, fluorenylidenemethane derivatives; anthrone derivatives; distyrylpyrazine derivatives; organometallic complexes such as beryllium bis(10-benzo[h]quinolinolate), beryllium 5-hydroxyflavonide, aluminum 5-hydroxyflavonide, etc.; metallic complexes with 8-hydroxyquinoline and its derivatives, in particular, metallic chelate oxinoid compounds including chelates of oxine, which is 8-quinolinol or 8-hydroxyquinoline in general, for example, aluminum tris(8-quinolinolate), aluminum tris(5,7-dichloro-8-quinolinolate), aluminum tris(5,7-dibromo-8-quinolinolate), aluminum tris(2-methyl-8-quinolinolate), etc.

The central metal of these metallic complexes may be replaced with indium, magnesium, copper, calcium, tin, or lead. Metal or non-metal phthalocyanines or those end-substituted with an alkyl group, a sulphone group, etc. can also be used.

The hole-transporting materials may be those having the above mentioned properties. For example, the following materials can also be used:
distyrylbenzene derivatives, distyrylamine derivatives, triarylamine derivatives, azomethyne derivatives, distyrylarylene derivatives, oxadiazole derivatives, dicarbazole derivatives, oligothiophene derivatives, tetraphenylbutadiene derivatives, benzopyran derivatives, triazole derivatives, benzoxazole derivatives, benzothiazole derivatives, etc.

Preferably, distyrylarylene derivatives, stilbene derivatives, carbazole derivatives, triarylamine derivatives, and more preferably, *N,N*'-bis(4'-diphenylamino-4-biphenylyl)-*N,N*'-diphenylbenzidine are used.

Of the above materials, those not emitting a light upon formation of non-light-emitting layer (13) are suitably selected also because of the above reasons.

Further, at least one of electron-transporting materials may be the same as at least one of materials contained/used in electron-injecting-transporting layer (14). The electron-transporting materials contained in electron-injecting-transporting layer (14) can also be used.

The reason why lifetime can be elongated, non-light-emitting layer (13) can be less damaged, or the electron-transporting materials of non-light-emitting layer (13) can be less damaged even if thus constructed is because non-light-emitting layer (13) contains a hole-transporting material. Since the hole-transporting material has resistance against holes and excitons, damages of non-light-emitting layer (13) can be reduced even if it contains the electron-transporting material contained in electron-injecting-transporting layer (14) compared to a layer consisting only of the electron-transporting material.

Further, at least one of hole-transporting materials may be the same as at least one of materials contained/used in light-emitting layer (12). In order not to emit a light in non-light-emitting layer (13), for example, the followings are acceptable.
i) As noted below, light-emitting layer (12) consists of a host and a dopant and the host is used as the hole-transporting material of non-light-emitting layer (13). In this case, the host itself does not generate luminescence. No light-emitting peak can be found.
ii) A material is used which is a material for light-emitting layer (12) but is not contained in light-emitting layer (12) and does not generate luminescence, i.e. no light-emitting peak can be found, when contained in non-light-emitting layer (13).

### < Manufacturing method >

Non-light-emitting layer (13) can be prepared with the above material(s) by a known film-forming method to form layers of organic EL devices such as a sputtering method, an ion-plating method, a vacuum-vapor-deposition method, a spin-coating method, an electron-beam vapor-deposition method, etc. on light-emitting layer (12). For example, aluminium tris(8-quinolinolate) as an electron-transporting material and aluminium bis(2-methyl-8-quinolinolate)(*p*-phenylphenolate) as a hole-transporting material were used and co-vapor-deposited onto light-emitting layer (12) to form non-light-emitting layer (13). Non-light-emitting layer (13) thus formed had the above mentioned effects, which were elongated lifetime etc., of non-light-emitting layer (13). No luminescence from non-light-emitting layer (13), i.e. no light-emitting peak from aluminium tris(8-quinolinolate) etc., was observed.

Although depending upon the material(s) used, the thickness of non-light-emitting layer (13) generally is around 0.5 nm-50 nm.

As noted above, lamination of non-light-emitting layer (13) between light-emitting layer (12) and electron-injecting-transporting layer (14) of the present organic EL devices can elongate their lifetime compared to conventional ones not having non-light-emitting layer (13).

The present organic EL device having non-light-emitting layer (13) was prepared to clarify less change in chromaticity by current through the present organic EL device, i.e. by brightness, than that in conventional organic EL devices not having non-light-emitting layer (13).

Hereinafter, layers other than the non-light-emitting layer will be set forth.

### << Anode (10) >>

Anode (10) is an electrode to inject holes into hole-injecting-transporting layer (11). Materials for anode (10) may thus be any materials that give this property to anode (10). In general, known materials such as metals, alloys, electrically conductive compounds, mixtures thereof, etc. are selected.

Materials for anode (10) are for example the followings:
metal oxides and metal nitrides such as indium-tin oxides (ITO), indium-zinc oxides (IZO), tin oxides, zinc oxides, zinc-aluminium oxides, titanium nitride, etc.;
metals such as gold, platinum, silver, copper, aluminium, nickel, cobalt, lead, chromium, molybdenum, tungsten, tantalum, niobium, etc.;
alloys of these metals and copper iodides;
conductive polymers such as polyanilines, polythiophenes, polypyrroles, polyphenylene vinylenes, poly(3-methylthiophene), polyphenylene sulphides, etc.

In cases where anode (10) is on the light-emitting surface side relatively to light-emitting layer (12), transparency of anode (10) to lights to be obtained is in general set to be greater than 10 %. In cases of obtaining visible lights, ITO can preferably be used whose transparency is high to them.

In cases where anode (10) is used as a reflective electrode, materials reflective to lights to be obtained are suitably selected from the above materials. In general, metals, alloys, and metal compounds are selected.

Anode (10) may be formed with only one kind of or a plurality of the above materials. Anode (10) may have a plurality of layers having identical or different composition(s).

If resistance of anode (10) is large, it is better that an auxiliary electrode is used to lower the resistance. The auxiliary electrode is made of a metal such as copper, chromium, aluminium (alloy), titanium, etc. or of a laminate thereof and is in partially combined use with anode (10).

Anode (10) is formed with the above material(s) by a known thin film-forming method such as a sputtering method, an ion-plating method, a vacuum-vapor-deposition method, a spin-coating method, an electron-beam vapor-deposition method, etc.

It is better to clean the surface of anode (10) with ozone, oxygen-plasma, or UV in order to increase the work function of the surface. In order to reduce generations of shortcuts and defects of the present organic EL devices, it is better to reduce the square mean value of the roughness of the surface to 20 nm or less by particle-size-minimisation or by abrasion of anode (10) after formed.

Although depending upon the material(s) used, the thickness of anode (10) is in general around 5 nm-1 µm, preferably around 10 nm-1 µm, more preferably around 10 nm-500 nm, in particular around 10 nm-300 nm, and most desirably around 10 nm-200 nm.

Electric resistance per sheet of anode (10) is set to be preferably several hundreds Ω/sheet or less, more preferably around 5-50 Ω/sheet.

### << Hole-injecting-transporting layer (11) >>

Hole-injecting-transporting layer (11) is laminated between anode (10) and light-emitting layer (12) and transports holes injected from anode (10) to light-emitting layer (12). In general, the ionisation potential of hole-injecting-transporting layer (11) is set to be between the work function of anode (10) and the ionisation potential of light-emitting layer (12) and usually is set to be 5.0 eV-5.5 eV.

Due to hole-injecting-transporting layer (11), the present organic EL device illustrated in Fig. 1 has the following features:
i) a lower driving-voltage;
ii) stabilised injection of holes from anode (10) into light-emitting layer (12) and the resulting longer lifetime of the present organic EL devices;
iii) improved adhesion between anode (10) and light-emitting layer (12) and the resulting more highly uniform light-emitting surfaces; and
iv) coating projections etc. of anode (10) and thus decreasing defects of the present organic EL devices.

In cases where hole-injecting-transporting layer (11) is on the light-emitting surface side relatively to light-emitting layer (12), hole-injecting-transporting layer (11) is formed to be transparent to lights to be obtained. Materials in a thin film form transparent to the above lights are suitably selected from materials for hole-injecting-transporting layer (11). Transparency of hole-injecting-transporting layer (11) to the lights to be obtained should in general be greater than 10 %.

Materials for hole-injecting-transporting layer (11) can be those capable of giving the above properties to hole-injecting-transporting layer (11). Of known materials as hole-injecting materials for photoconduction or for hole-injecting-transporting layers of organic EL devices, any material(s) can be selected and used.

Examples of such materials include phthalocyanine derivatives, triazole derivatives, triarylmethane derivatives, triarylamine derivatives, oxazole derivatives, oxadiazole derivatives, hydrazone derivatives, stilbene derivatives, pyrazoline derivatives, pyrazolone derivatives, polysilane derivatives, imidazole derivatives, phenylenediamine derivatives, amino-substituted chalcone derivatives, styrylanthracene derivatives, fluorene derivatives, silazane derivatives, aniline co-polymers, porphyrin compounds, polyaryl alkane derivatives, polyphenylene vinylene and its derivatives, polythiophene and its derivatives, poly-N-vinylcarbazole derivatives, conductive oligomers such as thiophene oligomers, aromatic tertiary amine compounds, styrylamine compounds, etc.

Triarylamine derivatives are for example 4,4'-bis[*N*-phenyl-*N*-(4"-methylphenyl)amino]biphenyl, 4,4'-bis[*N*-phenyl-*N*-(3"-methylphenyl)amino]biphenyl, 4,4'-bis[*N*-phenyl-*N*-(3"-methoxylphenyl)amino]biphenyl, 4,4'-bis[*N*-phenyl-*N*-(1"-naphthyl)amino]biphenyl, 3,3'-dimethyl-4,4'-bis[*N*-phenyl-*N*-(3"-methylphenyl)amino]biphenyl, 1,1-bis[4'-[*N*,*N*-di(4"-methylphenyl)amino]phenyl]cyclohexane, 9,10-bis[*N*-(4'-methylphenyl)-*N*-(4"-*n*-butylphenyl)amino]phenanthrene, 3,8-bis(*N*,*N*-diphenylamino)-6-phenylphenanthridine, 4-methyl-*N*,*N*-bis[4",4"'-bis[*N'*,*N"*-di(4-methylphenyl)amino]biphenyl-4-yl]-aniline, *N*,*N*"-bis[4-(diphenylamino)phenyl]-*N*,*N*'-diphenyl-1,3-diaminobenzene, *N*,*N*'-bis[4-(diphenylamino)phenyl]-*N*,*N*'-diphenyl-1,4-diaminobenzene, 5,5"-bis[4-[bis(4-methylphenyl)amino]phenyl]-2,2':5',2"-terthiophene, 1,3,5-tris(diphenylamino)benzene, 4,4',4"-tris(*N*-carbazolyl)triphenylamine, 4,4',4"-tris[*N*-(3"'-methylphenyl)-N-phenylamino]triphenylamine, 4,4',4"-tris[*N,N*-bis(4"'-tert-butylbiphenyl-4""-yl)amino]triphenylamine, 1,3,5-tris[*N*-(4'-diphenylaminophenyl)-N-phenylamino]benzene, trimers of triphenylamine, *N,N*'-bis(4'-diphenylamino-4-biphenylyl)-*N,N'*-diphenyl-benzidine, etc.

Porphyrin compounds are for example porphin, 1,10,15,20-tetraphenyl-21H,23H-porphin copper(II), 1,10,15,20-tetraphenyl-21H,23H-porphin zinc(II), 5,10,15,20-tetrakis(pentafluorophenyl)-21H,23H-porphin, silicon phthalocyanine oxide, aluminum phthalocyanine chloride, phthalocyanine free from metals, dilithium phthalocyanine, copper tetramethylphthalocyanine, copper phthalocyanine, chromium phthalocyanine, zinc phthalocyanine, lead phthalocyanine, titanium phthalocyanine oxide, magnesium phthalocyanine, copper octamethylphthalocyanine, etc.

Aromatic tertiary amine compounds and styrylamine compounds are for example *N*,*N*,*N*'*N*'-tetraphenyl-4,4'-diaminophenyl, *N*,*N*'-diphenyl-*N*,*N*'-bis(3-methylphenyl)-(1,1'-biphenyl)-4,4'-diamine, 2,2-bis(4-di-*p*-tolylaminophenyl)propane, 1,1-bis(4-di-*p*-tolylaminophenyl)cyclohexane, *N*,*N*,*N*'*N*'-tetra*-p*-tolyl-4,4'-diaminophenyl, 1,1-bis(4-di-*p*-tolylaminophenyl)-4-phenylcyclohexane, bis(4-dimethylamino-2-methylphenyl)phenylmethane, bis(4-di-*p*-tolylaminophenyl)phenylmethane, *N*,*N*'-diphenyl-*N*,*N*'-di(4-methoxyphenyl)-4,4'-diaminobiphenyl, *N,N,N'N'*-tetraphenyl-4,4'-diaminophenyl ether, 4,4'-bis(diphenylamino)-quadriphenyl, *N,N,N*-tri(p-tolyl)amine, 4-(di-*p*-tolylamino)-4'-[4-(di-p-tolylamino)styryl]stilbene, 4-*N,N*-diphenylamino-2-diphenylvinylbenzene, 3-methoxy-4'-*N,N*-diphenylaminostilbene, *N*-phenylcarbazole, etc. Aromatic dimethylidene compounds can also be used as materials for hole-injecting-transporting layer (11).

Hole-injecting-transporting layer (11) may be formed with one kind of or a mixture of a plurality of the above materials. Hole-injecting-transporting layer (11) may consist of a plurality of layers having identical or different composition(s).

Hole-injecting-transporting layer (11) may be formed with the above material(s) on the anode by a known thin film-forming method such as a vacuum-vapor-deposition method, a spin-coating method, a casting method, LB method, etc.

Although depending upon the material(s) selected, the thickness of hole-injecting-transporting layer (11) is usually 5 nm-5 µm.

### << Light-emitting layer (12) >>

Light-emitting layer (12) consists mainly of organic materials. From anode (10) side holes are injected and from cathode (15) side electrons are injected. Light-emitting layer (12) transports at least one of the holes and electrons, allows them to be re-combined, generates excitons, and generates EL upon return of the excitons to the base state.

Accordingly, (organic) materials for light-emitting layer (12) have only to have the following functions:
i) A transporting function to transfer at least one of injected holes and electrons by electric field force;
ii) a function to generate an excited state or excitons by re-combining electrons with holes; and
iii) a function to generate EL upon return of the excitons from the exited state to the base state.

Representative materials having the above functions are for example aluminum tris(8-quinolinolate) and Be-benzoquinolinol.

The following materials can also be used:
fluorescent brightening agents such as:
   benzoxazoles such as 2,5-bis(5,7-di-*tert*-pentyl-2-benzoxazolyl)-1,3,4-thiadiazole, 4,4'-bis(5,7-pentyl-2-benzoxazolyl)stilbene, 4,4'-bis[5,7-di(2-methyl-2-butyl)-2-benzoxazolyl]stilbene, 2,5-bis(5,7-di-*tert*-pentyl-2-benzoxazolyl)thiophene, 2,5-bis[(5-α,α-dimethylbenzyl)-2-benzoxazolyl]thiophene, 2,5-bis[5,7-di(2-methyl-2-butyl)-2-benzoxazolyl]-3,4-diphenylthiophene, 2,5-bis(5-methyl-2-benzoxazolyl)thiophene, 4,4'-bis(2-benzoxazolyl)biphenyl, 5-methyl-2-[2-[4-(5-methyl-2-benzoxazolyl)phenyl]vinyl]-benzoxazolyl, 2-[2-(4-chlorophenyl)vinyl]naphtho[1,2-d]oxazole, etc.;
   benzothiazoles such as 2,2'-(*p*-phenylenedivinylene)bisbenzothiazole etc.; and
   benzimidazoles such as 2-[2-[4-(2-benzimidazolyl)phenyl]vinyl] benzimidazole, 2-[2-(4-carboxyphenyl)vinyl]benzimidazole, etc.;
   phosphorescent materials such as:
      metal 8-hydroxyquinolate complexes such as magnesium bis(8-quinolinolate), zinc bis(benzo-8-quinolinolate), aluminium oxide bis(2-methyl-8-quinolinolate), indium tris(8-quinolinolate), aluminum tris(5-methyl-8-quinolinolate), lithium 8-quinolinolate, gallium tris(5-chloro-8-quinolinolate), calcium bis(5-chloro-8-quinolinolate), poly[zinc bis(8-hydroxy-5-quinolinolyl)methane], etc.;
      metal chelating oxinoid compounds such as dilithium epindolidione, etc.;
      styrylbenzene compounds such as 1,4-bis(2-methylstyryl)benzene, 1,4-(3-methylstyryl)benzene, 1,4-bis(4-methylstyryl)benzene, distyrylbenzene, 1,4-bis(2-ethylstyryl)benzene, 1,4-bis(3-ethylstyryl)benzene, 1,4-bis(2-methylstyryl)-2-methylbenzene, etc.;
      distilpyrazine derivatives such as 2,5-bis(4-methylstyryl)-pyrazine,
      2,5-bis(4-ethylstyryl)pyrazine,
      2,5-bis[2-(1-naphthyl)vinyl]pyrazine,
      2,5-bis(4-methoxylstyryl)pyrazine,
      2,5-bis[2-(4-biphenyl)vinyl]pyrazine,
      2,5-bis[2-(1-pyrenyl)vinyl]pyrazine, etc.;
      naphthalimide derivatives;
      perylene derivatives;
      oxadiazole derivatives;
      aldazine derivatives;
      cyclopentadiene derivatives;
      styrylamine derivatives;
      coumarin derivatives;
      aromatic dimethylidene derivatives;
      anthracene;
      salicylates;
      pyrenes;
      coronene;
      iridium tris(2-phenylpyridine), etc.

Light-emitting layer (12) may contain both a material having a function generating EL, which is an organic light-emitting material or a dopant, and a material having other functions, which is a host. In this case, the host injects and transports carriers and then is excited by re-combining. The excited host transfers the exciting energy to the dopant. It is also a possible mechanism that the host transports carriers to the dopant and allows re-combination within the dopant, generating lights upon return of the dopant to the base state. Dopants generate EL upon their return to the base state. As dopants, in general, fluorescent or phosphorescent materials are used.

Hosts have only to have the above functions and as the hosts known materials can be used. For example:
distyrylarylene derivatives, distyrylbenzene derivatives, distyrylamine derivatives, metal-quinolinolate complexes, triarylamine derivatives, azomethyne derivatives, oxadiazole derivatives, pyrazoloquinoline derivatives, silole derivatives, naphthalene derivatives, anthracene derivatives, dicarbazole derivatives, perylene derivatives, oligothiophene derivatives, tetraphenylbutadiene derivatives, benzopyran derivatives, triazole derivatives, benzoxazole derivatives, and benzothiazole derivatives

can be used.

Fluorescent materials are fluorescent pigments or fluorescent dopants. They generate luminescence by energy obtained from hosts upon transition to the base state. In general, materials having a high fluorescent quantum efficiency are selected and added in an amount of 0.01-20 weight % to the host.

Fluorescent materials are suitably selected from known materials, having the above properties, for example which are:
europium (Eu)-complexes, benzopyran derivatives, rhodamine derivatives, benzothioxanthene derivatives, porphyrin derivatives, Nile Red, hydro-1,1,7,7-tetramethyl-1H,5H-benzo-[i,j]quinolidin-9-yl]ethenyl]-4H-pyran-4H-ylidene]propanedinitrile, 4-dicyanomethylene-2-methyl-6-(*p*-dimethylaminostyryl)-4H-pyran, coumarin derivatives, quinacridone derivatives, distyrylamine derivatives, pyrene derivatives, perylene derivatives, anthracene derivatives, benzoxazole derivatives, benzothiazole derivatives, benzimidazole derivatives, chrysene derivatives, phenanthrene derivatives, distyrylbenzene derivatives, tetraphenylbutadiene, rubrene, etc.

Phosphorescent materials are phosphorescent pigments or phosphorescent dopants. They generate luminescence by energy obtained from hosts upon transition to the base state and can utilise luminescence from the singlet or triplet of the excited state at an ambient temperature. In general, the doped amount of the phosphorescent materials is 0.01-30 weight % to the host.

Phosphorescent materials can be any ones capable of utilising luminescence from the singlet or triplet of the excited state at an ambient temperature. Known materials selected as phosphorescent materials for light-emitting layers can be used. In general, phosphorescent heavy metal complexes are likely to be used.

For example, as a green phosphorescent material, iridium tris(2-phenylpyridine) can be used. As a red phosphorescent material, platinum(II) 2,3,7,8,12,13,17,18-octaethyl-21H,23H-porphin can be used. Further, the central metal in these materials may be replaced with another metal.

Light-emitting layer (12) may be formed on hole-injecting-transporting layer (11) by a known thin film-forming method such as a vacuum-vapor-deposition method, a spin-coating method, a casting method, LB method, etc.

Although depending upon the material(s) used, the thickness of light-emitting layer (12) is generally around 1 nm-100 nm and preferably around 2 nm-50 nm.

Addition of a plurality of dopants to the same layer allows emitted colors to be mixed, two or more lights to be emitted, and after transfer of energy from the host to a first dopant at a low energy level, the energy to be efficiently transferred further to a second dopant at a lower energy level. It is also a possible mechanism that the host transports a carrier to the dopant and allows re-combination within the dopant, generating luminescence upon return of the dopant to the base state.

Adjustments of chromaticity, chroma, brightness, luminance, etc. of luminescence (EL) from light-emitting layer (12) can be carried out by selection of kinds of materials forming light-emitting layer (12), of addition amounts, and of the thickness of light-emitting layer (12).

The following procedures also are possible to adjust emitted colors from light-emitting layer (12). Using one or more of these procedures, the emitted colors may be adjusted.
i) A procedure to set a color filter on the light-emitting surface side relatively to light-emitting layer (12).
   The color filter adjusts the emitted colors by limitation of transmission wave lengths. As the color filter, known materials, for example, as a blue filter cobalt oxide, as a green filter a mixture system of cobalt oxide and chromium oxide, and as a red filter iron oxide may be used and the color filter may be formed on substrate (2) using for example a known thin-film forming method such as a vacuum-vapor-deposition method.
ii) A procedure to add a material promoting or inhibiting luminescence.
   For example, addition of a so-called assisting-dopant which receives energy from a host and then transfers this energy to a dopant can facilitate the energy transfer from the host to the dopant. The assisting-dopant is suitably selected from known materials, for example, from the above materials capable of being utilised as a host or a dopant.
iii) A procedure to add a wave-length converting material to a layer, including substrate (2), located on the light-emitting surface side relatively to light-emitting layer (12).

As this material, known wave-length converting materials can be used. For example, fluorescence-converting materials can be used which convert the light emitted from light-emitting layer (12) into another light of a lower-energy wave length. Kinds of fluorescence-converting materials are suitably selected depending upon the wave length of the light desired to be generated from the present organic EL device and upon that from light-emitting layer (12). The amount of fluorescence-converting materials used can be suitably selected depending upon the kind(s) of fluorescence-converting materials without concentration quenching and is suitably around 10⁻⁵-10⁻⁴ mol/L to a transparent resin uncured. One or more fluorescence-converting material(s) may be used. If a plurality of fluorescence-converting materials are in combined use, the combination can provide white lights and intermediate lights as well as blue, green, and red lights. Concrete examples of fluorescence-converting materials are shown in (a)-(c) below.
(a) Those emitting a blue light by excitation with an UV light.
   Stilbene pigments such as 1,4-bis(2-methylstyryl)benzene, *trans*-4,4'-diphenylstilbene, etc.;
   coumarin pigments such as 7-hydroxy-4-methylcoumarin, etc.; and
   pigments such as 4,4'-bis(2,2'-diphenylvinyl)biphenyl, etc.
(b) Those emitting a green light by excitation with a blue light.
   Coumarin pigments such as 2,3,5,6-1H,4H-tetrahydro-8-trifluoromethylquinolidino[9,9a,1-gh]coumarin etc.
(c) Those emitting an orange-red light by excitation with a blue-green light Cyanine pigments such as 4-(dicyanomethylene)-2-methyl-6-(*p*-dimethylaminostyryl)-4H-pyran,
   4-(dicyanomethylene)-2-phenyl-6-[2-(9-julolidyl)ethenyl)]-4H-pyran,
   4-(dicyanomethylene)-2,6-di[2-(9-julolidyl)ethenyl)]-4H-pyran,
   4-(dicyanomethylene)-2-methyl-6-[2-(9-julolidyl)ethenyl)]-4H-pyran,
   4-(dicyanomethylene)-2-methyl-6-[2-(9-julolidyl)ethenyl)]-4H-thiopyran, etc;
   pyridine pigments such as 1-ethyl-2-[4-(*p*-dimethylaminophenyl)-1,3-butadienyl]pyridium perchlorate (Pyridine 1) etc.;
   xanthine pigments such as Rhodamine B, Rhodamine 6G, etc.;
   oxazine pigments; etc.

The above mentioned effects can be obtained especially when light-emitting layer (12) has a hole-transporting property.

If light-emitting layer (12) has a hole-transporting property, more holes do not re-combine with an electron and do enter electron-injecting-transporting layer (13). Accordingly, lamination of non-light-emitting layer (13) in such an organic EL device can so much elongate its lifetime.

### « Electron-injecting-transporting layer (14) »

Electron-injecting-transporting layer (14) is laminated between non-light-emitting layer (13) and cathode (15), transports electrons injected from cathode (15) to non-light-emitting layer (13), and gives the above properties to the present organic EL devices.

Materials for electron-injecting-transporting layer (14) are any materials selected from known materials for electron-injecting materials of photoconduction and for electron-injecting-transporting layers of organic EL devices. In general, materials whose electron-affinity is between the work function of the cathode and the electron-affinity of non-light-emitting layer (13) are used.

In particular, oxadiazole derivatives such as 1,3-bis[5'-(*p*-*tert*-butylphenyl)-1,3,4-oxadiazol-2'-yl]benzene, 2-(4-biphenylyl)-5-(4-*tert*-butylphenyl)-1,3,4-oxadiazole, etc.; triazole derivatives such as 3-(4'-*tert*-butylphenyl)-4-phenyl-5-(4"-biphenyl)-1,2,4-triazole etc.; etc. can also be used. Triazine derivatives; perylene derivatives; quinoline derivatives; quinoxaline derivatives; diphenylquinone derivatives; nitro-substituted fluorenone derivatives; tetraphenylmethane derivatives, thiopyran dioxide derivatives; anthraquinodimethane derivatives; heterocyclic tetracarboxylic acid anhydrides such as naphthaleneperylene, carbodiimide, fluorenylidenemethane derivatives; anthrone derivatives; distyrylpyrazine derivatives; phenanthroline derivatives; etc. can also be used.

Organometallic complexes such as beryllium bis(10-benzo[h]-quinolinolate), beryllium 5-hydroxyflavonide, aluminum 5-hydroxyflavonide, etc. can also be selected preferably and metallic complexes with 8-hydroxyquinoline or its derivatives can in particular also be selected preferably. In particular, metallic chelate oxinoid compounds including chelates of oxine, which is 8-quinolinol or 8-hydroxyquinoline in general, for example, aluminum tris(8-quinolinolate), aluminum tris(5,7-dichloro-8-quinolinolate), aluminum tris(5,7-dibromo-8-quinolinolate), aluminum tris(2-methyl-8-quinolinolate), etc. The central metal of these metallic complexes may be replaced with indium, magnesium, copper, calcium, tin, or lead. Metal or non-metal phthalocyanines or those end-substituted with an alkyl group, a sulphone group, etc. can also be used preferably.

Electron-injecting-transporting layer (14) may consist of only one of the above materials or of a mixture of a plurality of them. Electron-injecting-transporting layer (14) may consist of a plurality of layers having identical or different composition(s).

Electron-injecting-transporting layer (14) is formed with the above material(s) by a known thin-film forming method such as a sputtering method, an ion-plating method, a vacuum-vapor-deposition method, a spin-coating method, an electron-beam vapor-deposition method, etc.

Although depending upon the material(s) used, the thickness of electron-injecting-transporting layer (14) is usually 5 nm-5 µm.

When electron-injecting-transporting layer (14) is located on the light-emitting surface side relatively to light-emitting layer (12), electron-injecting-transporting layer (14) should be transparent to lights to be emitted. Therefore, materials in a thin-film form transparent to the lights are suitably selected from the above materials for electron-injecting-transporting layer (14), whose transparency is set generally to be more than 10 % to the lights.

### << Cathode (15) >>

Cathode (15) injects electrons into electron-injecting-transporting layer (14). In order to increase electron-injecting efficiency, metals, alloys, electrically conductive compounds, and mixtures thereof whose work function for example is less than 4.5 eV are used for cathode (15).

Such cathode materials are for example lithium, sodium, magnesium, silver, copper, aluminum, indium, calcium, tin, ruthenium, titanium, manganese, chromium, yttrium, aluminum-calcium alloy, aluminum-lithium alloy, aluminum-magnesium alloy, magnesium-silver alloy, magnesium-indium alloy, lithium-indium alloy, sodium-potassium alloy, magnesium/copper mixtures, aluminum/aluminum oxide mixtures, etc. Anode materials can also be used.

When cathode (15) is located on the light-emitting surface side relatively to light-emitting layer (12), cathode (15) should in general be of transparency of more than 10 % to lights to be obtained. For example, electrodes formed by lamination of a transparent conductive oxide onto a very thin film of a Mg-Ag alloy are used. Upon sputtering the conductive oxide in this cathode, in order to prevent organic light-emitting layer (31) etc. from being damaged by plasma, a buffering layer to which copper-phthalocyanine etc. is added may be laminated between cathode (15) and electron-injecting-transporting layer (14).

When cathode (15) is used as a light-reflective electrode, materials capable of reflection of emitted lights are selected suitably from the above materials. In general, metals, alloys, and metal compounds are selected.

Cathode (15) may be formed with only one of or a plurality of the above materials. For example, addition of 1 %-20 % of silver or copper to magnesium or addition of 0.1 %-10 weight % of lithium to aluminum can prevent oxidation of cathode (15) and can improve adhesion of cathode (15) with electron-injecting-transporting layer (14).

Cathode (15) may consist of a plurality of layers having identical or different composition(s). For example, the following structures may be used.
i) In order to prevent oxidation of cathode (15), a protective layer made of a corrosion-resistant metal is formed in or on a portion of cathode (15) not contacting with electron-injecting-transporting layer (14).
   As materials for this protective layer, for example, silver, aluminum, etc. are used preferably.
ii) In order to decrease the work function of cathode (15), an oxide, a fluoride, a metal, a compound, etc. whose work function is low is inserted into the interface between cathode (15) and electron-injecting-transporting layer (14).
   For example, a material for cathode (15) is aluminium and lithium fluoride (LiF) or lithium oxide (Li2O) is inserted into the interface.

Cathode (15) can be formed by a known thin film-forming method such as a vacuum-vapor-deposition method, a sputtering method, an ionization-vapor-deposition method, an ion-plating method, an electron-beam vapor-deposition method, etc.

The thickness of cathode (15) is set to be generally around 5 nm-1 µm, preferably around 5 nm-1000 nm, more preferably around 10 nm-500 nm, and most desirably 50 nm-200 nm, although depending upon the electrode materials actually used.

Electric resistance per sheet of cathode (15) preferably is set to be several hundreds Ω/sheet or less.

### << Other layers and additives >>

The present organic EL devices according to the first embodiment may have known layers other than the layers illustrated in Fig. 1. To the layers of the present organic EL devices according to the first embodiment, known additives (dopants) etc. may be added (doped). For example, the following modifications are acceptable.

### < Interlayers >

Layers to improve adhesion between layers and to improve an electron- or hole-injecting property may be laminated.

For example, a cathode-interfacing layer where the materials of cathode (15) and of electron-injecting-transporting layer (14) are co-vapor-deposited may be laminated between cathode (15) and electron-injecting-transporting layer (14) thereby reducing the energy barrier against electron-injection existing between light-emitting layer (12) and cathode (15). Adhesion between cathode (15) and electron-injecting-transporting layer (14) can also be improved.

Materials for the cathode-interfacing layer can be any materials giving it the above properties. Known materials can also be used. For example, fluorides, oxides, chlorides, sulphides, etc. of alkali (earth) metals such as lithium fluoride (LiF), lithium oxide (Li₂O), magnesium fluoride (MgF₂), calcium fluoride (CaF₂), strontium fluoride (SrF₂), barium fluoride (BaF₂), etc. can be used. The cathode-interfacing layer may be formed with only one of or a plurality of the above materials.

The thickness of the cathode-interfacing layer is around 0.1 nm-10 nm and preferably 0.3 nm-3 nm.

The cathode-interfacing layer may be formed with an uniform or not uniform thickness or in a state of islands by a known thin film-forming method such as a vacuum-vapor-deposition method.

### < Protective layer >

In order to prevent contact of the present organic EL device with oxygen and/or water, a protective layer, that is a sealing layer or a passivation film, may be laminated.

Materials for the protective layer for example are organic polymeric materials, inorganic materials, and further photo-cured resins. Only one of or a combination of a plurality of the above materials may be used. The protective layer may consist of only one layer or of a lot of layers.

Examples of organic polymer materials can be chlorotrifluoroethylene polymers, dichlorodifluoroethylene polymers, fluoride resins such as co-polymers of a chlorotrifluoroethylene polymer and a dichlorodifluoroethylene polymer, acrylic resins such as polymethylmethacrylate, polyacrylate, etc., epoxy resins, silicone resins, epoxysilicone resins, polystyrene resins, polyester resins, polycarbonate resins, polyamide resins, polyimide resins, polyamidoimide resins, poly-para-xylene resins, polyethylene resins, polyphenylene oxide resins, etc.

Inorganic materials can be diamond thin film, amorphous silica, insulating glass, metal oxides, metal nitrides, metal carbides, metal sulphides, etc.

Further to the above materials, the above fluorescence-converting materials may be added.

The present organic EL devices can be protected for example by sealing in an inert material such as paraffin, liquid paraffin, a silicone oil, a fluorocarbon oil, a zeolite-added fluorocarbon oil, etc.

### < Doping into hole-injecting-transporting layer (11) and electron-injecting-transporting layer (14) >

Hole-injecting-transporting layer (11) and electron-injecting-transporting layer (14) may also be allowed to emit lights by doping of an organic light-emitting material (dopant) such as fluorescent or phosphorescent materials.

### < Doping of an alkali metal or its compound into the layer adjacent to cathode (15) >

If a metal such as aluminum (Al) is used as cathode (15), in order to reduce the energy barrier between cathode (15) and organic light-emitting layer (31), an alkali metal or its compound may be doped into the layer adjacent to cathode (15). The added metal or metal compound generates anions by reduction of the organic layer thereby increasing the electron-injecting property and resulting in a lower voltage to be applied. Alkali metal compounds can for example be oxides, fluorides, lithium chelates, etc.

### << Substrate (2) >>

Substrate (2) is usually in a plate form to support the present organic EL devices. In general, organic EL devices consist of very thin layers and thus are prepared on the support of such a substrate.

Since the present organic EL devices are formed on substrate (2), it preferably is planar and smooth.

In cases substrate (2) is located on the light-emitting surface side relatively to light-emitting layer (12), substrate (2) should be transparent to lights to be emitted.

Any known substrates can be used as substrate (2) if they have the above properties. In general, ceramic substrates such as glass substrates, silicon substrates, and quartz substrates; plastic substrates; etc. are selected. Metal substrates or substrates formed with a metal foil on a support are also used. Further, substrates consisting of a composite sheet of a combination of a plurality of identical or different substrates can also be used.

Thus, the present organic EL devices according to the first embodiment have only to have one of constructions (1)-(8) shown below and can suitably be modified in other points.
(1) On an anode, at least a light-emitting layer, an electron-injecting-transporting layer, and a cathode in this order are laminated and a non-light-emitting layer is laminated between said electron-injecting-transporting layer and said light-emitting layer, said non-light-emitting layer having a higher hole-transporting property than said electron-injecting-transporting layer has and having also an electron-transporting property
(2) In above (1), the electron-transporting property of said non-light-emitting layer is higher than its hole-transporting property.
(3) In above (1) or (2), said non-light-emitting layer contains a material having a higher hole-transporting property than said electron-injecting-transporting layer has and an electron-transporting property.
(4) In above (1) or (2), said non-light-emitting layer contains one or more electron-transporting material(s) having an electron-transporting property and one or more hole-transporting material(s) having a higher hole-transporting property than said electron-injecting-transporting layer has.
(5) In above (4), at least one electron-transporting material(s) is/are the same as at least one material(s) contained in said electron-injecting-transporting layer.
(6) In above (4) or (5), at least one hole-transporting material(s) is/are the same as at least one material(s) contained in said light-emitting layer.
(7) In any one of above (4)-(6), the electron-transporting property of said electron-transporting material is greater than the hole-transporting property of said hole-transporting material.
(8) In any one of above (1 )-(7), the hole-transporting property of said light-emitting layer is greater than its electron-transporting property.

### << Modifications >>

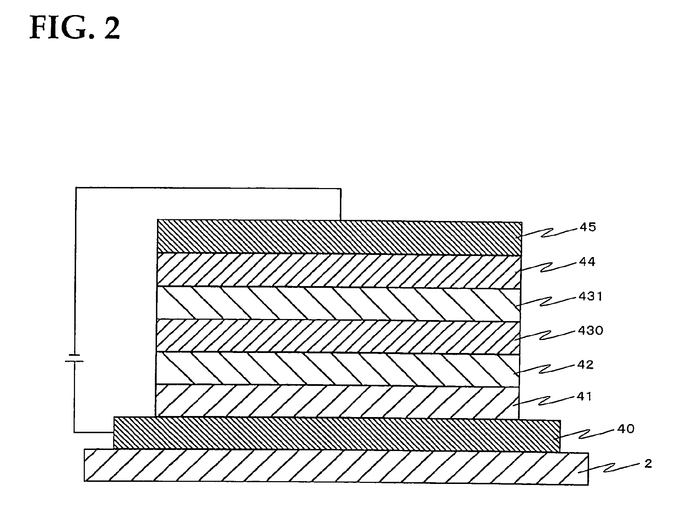

Accordingly, as illustrated for example in Fig. 2, the non-light-emitting layer may be constructed by lamination of a plurality of layers made of identical or different material(s) shown above. Figure 2 shows a construction where anode (40), hole-injecting-transporting layer (41), light-emitting layer (42), first non-light-emitting layer (430), second non-light-emitting layer (431), electron-injecting-transporting layer (44), and cathode (45) in this order are laminated on substrate (3). In this construction, the layers other than first non-light-emitting layer (430) and second non-light-emitting layer (431) correspond equivalently to the respective layers in the above first embodiment.

Also in such cases where the non-light-emitting layers are plural, non-light-emitting layers (430) and (431) can exert the above effects if the non-light-emitting layers are formed in the same way as the above first embodiment.

The organic EL devices, where second non-light-emitting layer (431) is made of a single material such as aluminum tris(8-quinolinolate) etc. and where first non-light-emitting layer (430) uses as an electron-transporting material the material for second non-light-emitting layer (431), that is aluminum tris(8-quinolinolate) in this example, and uses as a hole-transporting material the same material as that of light-emitting layer (42), were found to have an elongated lifetime and an increased light-emitting efficiency. In summary, constructions having hole-transporting properties gradually decreased from light-emitting layer (42) to electron-injecting-transporting layer (44) or electron-transporting properties gradually increased from light-emitting layer (42) to electron-injecting-transporting layer (44) can bring good effects.

This appears to be affected also by that each energy gap between the layers between light-emitting layer (42) and electron-injecting-transporting layer (44) can be decreased compared to that in conventional devices.

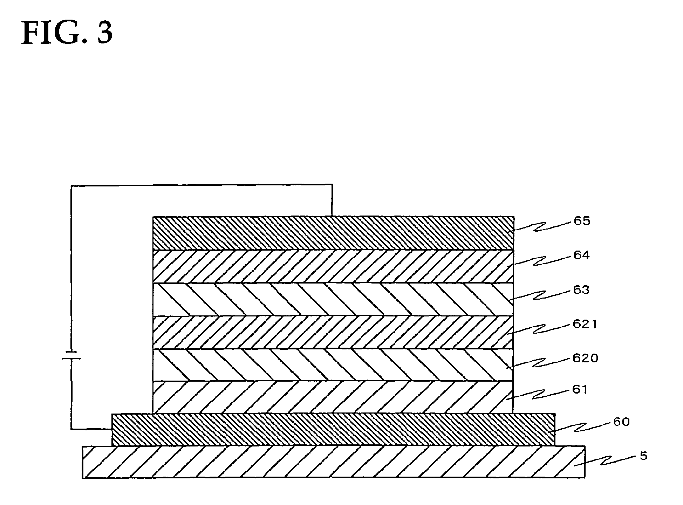

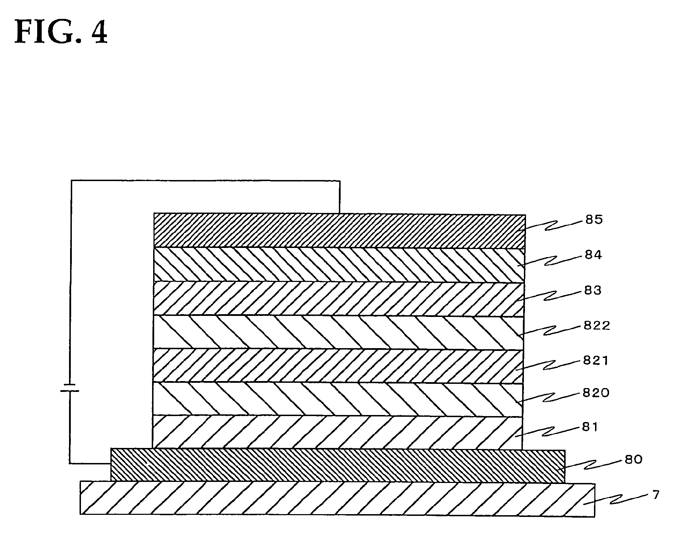

As shown in Fig. 3 and Fig. 4, the light-emitting layer can be allowed to consist of a plurality of layers, one of which can be allowed to generate a light having a peak different from that of at least another layer.

In the construction illustrated in Fig. 3, anode (60), hole-injecting-transporting layer (61), blue light-emitting layer (620), red-and-green light-emitting layer (621), non-light-emitting layer (63), electron-injecting-transporting layer (64), and cathode (65) in this order are laminated on substrate (5) to express white by emitting red, green, and blue lights. In this construction, the layers other than red-and-green light-emitting layer (621) and blue light-emitting layer (620) have only to be constructed in the same manner respectively as the corresponding layers of the organic EL device illustrated in Fig. 1.

Blue light-emitting layer (620) is preferably formed by mixing for example by co-vapor-deposition of a blue dopant and host on the side of cathode (65) relatively to red-and-green light-emitting layer (621).

As a dopant whose emitted color is blue, known blue dopants can suitably be used, which are for example distyrylamine derivatives, pyrene derivatives, perylene derivatives, anthracene derivatives, benzoxazole derivatives, benzothiazole derivatives, benzimidazole derivatives, chrysene derivatives, phenanthrene derivatives, distyrylbenzene derivatives, tetraphenylbutadiene, etc.

As a host for blue light-emitting layer (620), known hosts for light-emitting layers comprising a blue dopant of organic EL devices can suitably be used. For example, distyrylarylene derivatives, stilbene derivatives, carbazole derivatives, triarylamine derivatives, aluminum bis(2-methyl-8-quinolinolate)(p-phenylphenolate), etc. can be used.

Red-and-green light-emitting layer (621) is preferably formed by mixing for example by co-vapor-deposition of a red dopant, a green dopant, and a host.

Dopants whose emitted color is red or green can suitably be selected from known dopnats. Dopants whose emitted color is red are for example Eu-complexes, benzopyran derivatives, rhodamine derivatives, benzothioxanthene derivatives, porphyrin derivatives, Nile Red, 2-(1,1-dimethylethyl)-6-[2-(2,3,6,7-tetrahydro-1,1,7,7-tetramethyl-1H,5H-benzo [i,j]quinolidin-9-yl)ethenyl]-4H-pyran-4H-ylidene]propanedinitrile, 4-dicyanomethylene-2-methyl-6-(*p*-dimethylaminostyryl)-4H-pyran, etc. Dopants whose emitted color is green are for example coumarin derivatives, distyrylamine derivatives, quinacridone derivatives, etc.

As hosts used in red-and-green light-emitting layer (621), known hosts for light-emitting layers comprising a red dopant and/or a green dopant of organic EL devices can suitably be used. For example, distyrylarylene derivatives, distyrylbenzene derivatives, distyrylamine derivatives, metal-quinolinolate complexes, triarylamine derivatives, oxadiazole derivatives, silole derivatives, dicarbazole derivatives, oligothiophene derivatives, benzopyran derivatives, triazole derivatives, benzoxazole derivatives, benzothiazole derivatives, etc. can be used. Especially, aluminium tris(8-quinolinolate), *N*,*N*'-bis(4'-diphenylamino-4-biphenylyl)-*N*,*N'*-diphenylbenzidine, and 4,4'-bis(2,2'-diphenylvinyl)biphenyl are preferably used.

In the construction illustrated in Fig. 4, anode (80), hole-injecting-transporting layer (81), blue light-emitting layer (820), red light-emitting layer (821), green light-emitting layer (822), non-light-emitting layer (83), electron-injecting-transporting layer (84), and cathode (85) in this order are laminated on substrate (7) to express white by emitting red, green, and blue lights. In this construction, the layers other than blue light-emitting layer (820), red light-emitting layer (821), and green light-emitting layer (822) have only to be constructed in the same manner respectively as the corresponding layers of the organic EL device illustrated in Fig.1.

Blue light-emitting layer (820), red light-emitting layer (821), and green light-emitting layer (822) may be formed with mixtures of the above respective dopants and their suitable hosts.

As illustrated in Fig. 3 and Fig. 4, when the light-emitting layer consists of a plurality of layers and the non-light-emitting layer is made of an electron-transporting material and a hole-transporting material, it was found to provide good organic EL devices with an elongated lifetime that said hole-transporting material is the host of the light-emitting layer, adjacent to the non-light-emitting layer, that is red-and-green light-emitting layer (621) in Fig. 3 and green light-emitting layer (822) in Fig. 4.

### The second embodiment

### << Layer constructions >>

In the present organic EL devices according to the second embodiment, at least a red light-emitting layer, a blue light-emitting layer, and then a cathode in this order are formed on an anode, said red light-emitting layer containing a green light-emitting dopant.

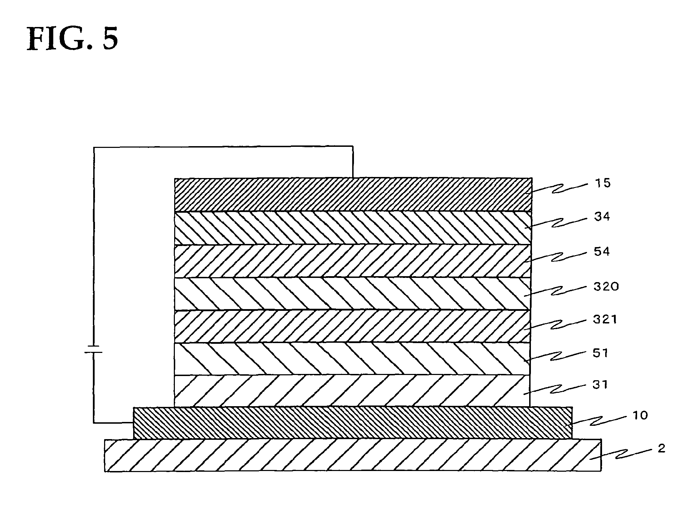

Figure 5 illustrates the present organic EL device wherein anode (10), hole-injecting layer (31), hole-transporting layer (51), red light-emitting layer (321), blue light-emitting layer (320), electron-transporting layer (54), electron-injecting layer (34), and then cathode (15) in this order are formed on substrate (2). The present organic EL devices according to the second embodiment will now be set forth in more detail with reference to Fig. 5.

### << Substrate (2) >>

Substrate (2) is usually in a plate form to support the present organic EL devices. In general, organic EL devices consist of very thin layers and thus are prepared on the support of such a substrate.

Since the present organic EL devices are formed on substrate (2), it preferably is flat and smooth.

In cases where substrate (2) is located on the light-emitting surface side, substrate (2) should be transparent to lights to be emitted.

Any known substrates can be used as substrate (2) if they have the above properties. In general, ceramic substrates such as glass substrates, silicon substrates, and quartz substrates; and plastic substrates are selected. Metal substrates or substrates formed with a metal foil on a support may also be used. Further, substrates consisting of a composite sheet of a plurality of identical or different substrates combined can also be used.

### << anode (10) >>

Anode (10) is an electrode to inject holes into hole-injecting-transporting layer (11). Materials for anode (10) may thus be any materials to give this property to anode (10). In general, known materials such as metals, alloys, electrically conductive compounds, any mixtures thereof, etc. are selected.

Materials for anode (10) include for example the followings:
metal oxides and metal nitrides such as indium-tin oxides (ITO), indium-zinc oxides (IZO), tin oxides, zinc oxides, zinc-aluminum oxides, titanium nitride, etc;
metals such as gold, platinum, silver, copper, aluminum, nickel, cobalt, lead, chromium, molybdenum, tungsten, tantalum, niobium, etc.;
alloys of these metals and copper iodides;
conductive polymers such as polyanilines, polythiophenes, polypyrroles, polyphenylene vinylenes, poly(3-methylthiophene), polyphenylene sulphides, etc.

In cases where anode (10) is located on the light-emitting surface side relatively to light-emitting layer (12), transparency of anode (10) to lights to be emitted should in general be greater than 10 %. In cases where a visible light is emitted, ITO is preferably used whose transparency is high to visible lights.

In cases where anode (10) is used as a reflective electrode, materials reflective to lights to be emitted are suitably selected from the above materials. In general, metals, alloys, and metal compounds are selected.

Anode (10) may be formed with only one kind of or with a mixture of a plurality of the above mentioned materials. Anode (10) may have also a plurality of layers having identical or different composition(s).

If resistance of anode (10) is large, an auxiliary electrode can be used to lower the resistance. Such auxiliary electrodes are made of a metal such as copper, chromium, aluminum, titanium, aluminum alloy, etc. or of a laminate thereof and are in partially combined use with anode (10).

Anode (10) is formed with the above mentioned material(s) by a known thin film-forming method such as a sputtering method, an ion-plating method, a vacuum-vapor-deposition method, a spin-coating method, an electron-beam vapor-deposition method, etc. on substrate (2).

It is preferable to clean the surface of anode (10) with ozone, oxygen-plasma, or with UV in order to increase the work function of the surface. In order to reduce shortcuts and defects of the present organic EL devices, it is preferable to reduce the square mean value of the surface roughness to 20 nm or less by a particle size-minimization method or by an abrasion method after anode (10) formed.

Although depending upon materials used, the thickness of anode (10) is in general around 5 nm-1 µm, preferably around 10 nm-1 µm, more preferably around 10 nm-500 nm, in particular preferably around 10 nm-300 nm, and most desirably around 10 nm-200 nm.

Electric resistance per sheet of anode (10) is set preferably to be several hundreds Ω/sheet or less, more preferably to be around 5-50 Ω/sheet.

### << Hole-injecting layer (31) >>

Hole-injecting layer (31) is laminated between anode (10) and hole-transporting layer (51). Hole-injecting layer (31) transports holes injected from anode (10) to hole-transporting layer (51). The thickness of hole-injecting layer (31) is preferably 0.5 nm-200 nm, more preferably 7 nm-150 nm. The reasons why such ranges of thickness are preferred are because a lower driving-voltage and a covering of projections of the anode can be achieved.

Materials to be used for hole-injecting layer (31) can be those capable of giving the above properties to hole-injecting layer (31). Any materials can be selected from known materials as hole-injecting materials for photoconduction and known materials used for hole-injecting layers of organic EL devices. For example, triarylamines, arylenediamine derivatives, phenylenediamine derivatives, styryl compounds, 2,2-diphenylvinyl compounds, porphyrin derivatives, etc., *inter alia*, *para*-phenylenediamine derivatives, 4,4'-diaminobiphenyl derivatives, 4,4'-diaminodiphenylsulphane derivatives, 4,4'-diaminodiphenylmethane derivatives, 4,4'-diaminodiphenyl ether derivatives, 4,4'-diaminotetraphenylmethane derivatives, 4,4'-diaminostilbene derivatives, 1,1-diarylcyclohexanes, 4,4"-diaminoterphenyl derivatives, 5,10-di-(4-aminophenyl)anthracene derivatives, 2,5-diarylpyridines, 2,5-diarylfurans, 2,5-diarylthiophenes, 2,5-diarylpyrroles, 2,5-diaryl-1,3,4-oxadiazoles, 4-(diarylamino)stilbenes, 4,4'-di(diarylamino)stilbenes, *N*,*N*-diaryl-4-(2,2-diphenylvinyl)anilines, 1,4-di(4-aminophenyl)naphthalene derivatives, 2,8-di(diarylamino)-5-thioxanthenes, 1,3-di(diarylamino)isoindoles, etc. are preferable. Tris[4-[*N*-(3-methylphenyl)-N-phenylamino]phenyl]amine, tris[4-[*N*-(2-naphthyl)-N-phenylamino]phenyl]amine, porphyrin-copper complexes, etc. are more preferable.

Hole-injecting layer (31) can be prepared with these materials by a known film-forming method such as a sputtering method, an ion-plating method, a vacuum-vapor-deposition method, a spin-coating method, an electron-beam vapor-deposition method, etc. on anode (10).

### << Hole-transporting layer (51) >>

Hole-transporting layer (51) is laminated between hole-injecting layer (31) and red light-emitting layer (321). Hole-transporting layer (51) transports holes transported from hole-injecting layer (31) to red light-emitting layer (321).

The thickness of hole-transporting layer (51) is preferably 0.5 nm-1000 nm, more preferably 10 nm-800 nm.

Materials capable of being used for hole-transporting layer (51) can be those with high performance of transporting holes. Examples of such materials include triamines, tetraamines, benzidines, triarylamines, arylene diamine derivatives, phenylenediamine derivatives, para-phenylene diamine derivatives, *meta*-phenylenediamine derivatives, 1,1-bis(4-diarylaminophenyl)-cyclohexanes, 4,4'-di(diarylamino)biphenyls, bis[4-(diarylamino)phenyl]-methanes, 4,4"-di(diarylamino)terphenyls, 4,4"'-di(diarylamino)quaterphenyls, 4,4'-di(diarylamino)diphenyl ethers, 4,4'-di(diarylamino)diphenylsulphanes, bis[4-(diarylamino)phenyl]dimethylmethanes, bis[4-(diarylamino)phenyl]-di(trifluoromethyl)methanes, etc. Amongst these, aryl di(4-diarylaminophenyl)amines, 4,4'-bis[*N*-(1-naphthyl)-*N*-phenylamino]-biphenyl, and the above materials preferable for hole-injecting layer (31) are preferable.

Hole-transporting layer (51) can be prepared with these materials by a known film-forming method such as a sputtering method, an ion-plating method, a vacuum-vapor-deposition method, a spin-coating method, an electron-beam vapor-deposition method, etc. on hole-injecting layer (31).

### << Red light-emitting layer (321) >>

Red light-emitting layer (321) is laminated between hole-transporting layer (51) and blue light-emitting layer (320) or an emission-adjusting layer. Red light-emitting layer (321) contains a green light-emitting dopant. Accordingly, on red light-emitting dopants and green light-emitting dopants in red light-emitting layer (321), holes injected from anode (10) and electrons injected from cathode (15) are re-combined, are excited, return to the base state, and then generate red and green lights. The thickness of red light-emitting layer (321) is preferably 0.5 nm-50 nm, more preferably 1 nm-20 nm.

Green light-emitting dopants contained in red light-emitting layer (321) can be any with a green light-emitting performance and are for example coumarin derivatives, quinacridone derivatives, metal-quinolinolate complexes, distyrylamine derivatives, etc. Coumarin derivatives are especially preferable due to their superior green light-emitting performance. 6-(Alkyl- or non-substituted)-8-(alkyl- or non-substituted)-7-amino-3-aryl-4-(trifluoromethyl- or non-substituted)coumarin delivatives are more preferable. In particular, considering π electron conjugation with the coumarin nucleus, the 3-aryl group preferably is benzothiazol-2-yl, benzimidazol-2-yl, benzoxazol-2-yl, benzoselenazol-2-yl, etc. These benzo-moieties in the aryl group may further be substituted. Green light-emitting dopants are preferably 0.1-15 parts by weight per 100 parts by weight of the hole-transporting hosts to give superior whiteness.

Further, red light-emitting layer (321) contains a hole-transporting host. Accordingly, red light-emitting layer (321) can have a hole-transporting function as of hole-transporting layer (51). Hole-transporting hosts used here can be any having a hole-transporting function and are for example benzidines, triamines, tetraamines, triarylamines, 4,4'-di(diarylamino)biphenyls, para-phenylenediamine derivatives, *meta*-phenylenediamine derivatives, 1,1-bis(4-diarylaminophenyl)cyclohexanes, aryl di(4-diarylaminophenyl)-amines, distyrylarylenes, distyrylbenzenes, distyrylamine derivatives, metal-quinolinolate complexes, azomethynes, oxadiazoles, pyrazoloquinolines, siloles, naphthalenes, anthracenes, dicarbazole derivatives, perylenes, oligothiophenes, coumarins, pyrenes, tetraarylbutadienes, benzopyrans, europium (Eu) complexes, rubrenes, quinacridone derivatives, triazoles, benzoxazoles, benzothiazoles, tetramers of triarylamines, etc. Amongst these, 4,4'-bis[*N*-(l-naphthyl)-*N*-phenylamino]biphenyl, 4,4'-bis[*N*-(3-methylphenyl)-*N*-phenylamino]biphenyl, aluminium tris(8-quinolinolate), 4,4'-bis(2,2'-diphenylvinyl)biphenyl, the above materials preferable for hole-injecting layer (31), etc. are preferable.

Further, red light-emitting layer (321) preferably contains at least one red light-emitting dopant(s) resulting in further improved whiteness of the present organic EL devices.

Red light-emitting dopants to be contained in red light-emitting layer (321) can be any having a red light-emitting performance and are for example anthracenes, tetracenes, pentacenes, pyrenes, Eu complexes, benzopyrans, 4-[two electron-withdrawing group (EWG) substituted methylidene)-4H-pyrans, 4-(two EWG substituted methylidene)-4H-thiopyrans, rhodamines, benzothioxanthenes, porphyrin derivatives, phenoxazones, periflanthenes, etc. Amongst these, 7-diethylaminobenzo[a]phenoxazin-9H-3-one, [2-*tert*-butyl-6-[*trans*-2-(2,3,5,6-tetrahydro-1,1,7,7-tetramethylbenzo[i,j]quinolidin-9-yl)ethenyl ]-4H-pyran-4-ylidene]-1,3-propanedinitrile, [2-methyl-6-[*trans-*2-(2,3,5,6-tetra-hydro-1,1,7,7-tetramethylbenzo[i,j]quinolidin-9-yl)ethenyl]-4H-pyran-4-ylidene]-1,3-propanedinitrile, dibenzotetraphenylperiflanthene, etc. are preferable. Red dopants are contained preferably in a range of 0.1-15 parts by weight per 100 parts by weight of the hole-transporting hosts to give superior whiteness.

Further, hole-mobility of red light-emitting layer (321) is preferable to be greater than that of blue light-emitting layer (320) thereby improving light-emitting efficiency.

Hole-mobility can be determined for example by Time of Flight (TOF) method. By TOF method, hole-mobility (its unit: cm²/V.s) can be calculated from the transient current, the voltage applied to the sample, and the thickness of the sample, the transient current being generated upon moving of holes within the sample layer, said holes generated by pulsed lights radiated onto the sample surface to which the voltage is applied. In particular, a film, for example of around 10-20 µm thickness, of a single layer whose hole-mobility is to be measured is prepared and then used for measuring the hole-mobility, proviso that the electric field intensity to be applied upon measuring the hole-mobility should be within that upon using the present organic EL devices.

Red light-emitting layer (321) can be prepared with these materials by a known film-forming method such as a sputtering method, an ion-plating method, a vacuum-co-vapor-deposition method, a spin-coating method, an electron-beam co-vapor-deposition method, etc. on hole-transporting layer (51).

### « Emission-adjusting Layer »

Between red light-emitting layer (321) and below mentioned blue light-emitting layer (320), an emission-adjusting layer preferably is laminated. This emission-adjusting layer can further improve the balance amongst emission intensities of red, green, and blue by blocking electrons. The thickness of this emission-adjusting layer is preferably 0.1 nm-30 nm, more preferably 0.5 nm-20 nm, to give superior whiteness.

Materials to be used in the emission-adjusting layer may be those capable of blocking electrons such as hole-transporting materials and are for example triarylamines, 4,4'-diaminobiphenyl derivatives, various materials preferable for hole-injecting layer (31), etc. Especially, due to superior electron-blocking performance, 4,4'-bis[*N*-(1-naphthyl)-*N*-phenylamino]-biphenyl *inter alia* is preferable.

The emission-adjusting layer can be prepared with these materials by a known film-forming method such as a sputtering method, an ion-plating method, a vacuum-vapor-deposition method, a spin-coating method, an electron-beam vapor-deposition method, etc. on red light-emitting layer (321).

### << Blue light-emitting layer (320) >>

Blue light-emitting layer (320) is laminated between red light-emitting layer (321) or the emission-adjusting layer and electron-transporting layer (54). In blue light-emitting layer (320), holes injected from anode (10) and electrons injected from cathode (15) are re-combined, are excited, return to the base state, and then emit blue lights. Materials capable of being used in blue light-emitting layer (320) can be selected from any known materials able to give blue light emission.

Blue light-emitting layer (320) is preferable to be thicker than that of red light-emitting layer (321) thereby further improving the balance amongst colors. The thickness of blue light-emitting layer (320) is preferably 1.1-8 times, more preferably 1.2-6 times, as thick as that of red light-emitting layer (321). More particularly, the thickness of blue light-emitting layer (320) is preferably 0.6 nm-70 nm, more preferably 5 nm-60 nm.

Blue light-emitting layer (320) preferably contains a bipolar host and a blue dopant resulting in an efficient blue light emission.

Bipolar hosts to be used in blue light-emitting layer (320) can be any materials having high hole- and electron-transporting performances and can for example be distyrylarylenes, stilbenes, carbazole derivatives, triarylamines, aluminum bis(2-methyl-8-quinolinolate)(*p*-phenylphenolate), 4,4'-bis(2,2-diarylvinyl)biphenyls, etc.

Blue dopants to be used in blue light-emitting layer (320) can be any capable of giving a blue light-emitting performance and can for example be pyrenes, perylenes, anthracenes, distyrylamine derivatives, benzoxazoles, metal-quinolinolate complexes, benzothiazoles, benzimidazoles, chrysenes, phenanthrenes, distyrylbenzenes, distyrylarylenes, divinylarylenes, trisstyryl arylenes, triaryl ethylenes, tetraarylbutadienes, etc. The doping amount of blue dopants is preferably 2-40 times, more preferably 5-30 times, by weight as much as that of red and green dopants to give a good balance between green lights from green dopants and red lights from red dopants, thereby giving an excellent white light.

Blue light-emitting layer (320) can be prepared with these materials by a known film-forming method such as a sputtering method, an ion-plating method, a vacuum-vapor-deposition method, a spin-coating method, an electron-beam vapor-deposition method, etc. on red light-emitting layer (321) or on the above emission-adjusting layer.

### « Electron-transporting layer 54 »

Electron-transporting layer (54) is laminated between blue light-emitting layer (320) and electron-injecting layer (34). Electron-transporting layer (54) transports electrons transported from electron-injecting layer (34) to blue light-emitting layer (320). The thickness of electron-transporting layer (54) is preferably 1 nm-50 nm, more preferably 10 nm-40 nm.

Electron-transporting layer (54) may consist of only one layer but is preferable to have two layers in view of less interaction such as formations of exciplexes, CT complexes, etc. of an electron-transporting material and a blue light-emitting layer material. This results in an elongated lifetime of the present organic EL devices.

In cases where electron-transporting layer (54) is made of only one layer, electron-transporting materials are selected suitably depending upon the required light-emitting efficacy and lifetime of the present organic EL devices. In particular, in view of improving light-emitting efficacy, it is preferable to use electron-transporting materials whose electron-mobility is large, whilst in view of elongating lifetime of the present organic EL devices, it is preferable to use electron-transporting materials whose electron-mobility is small.

In cases where electron-transporting layer (54) consists of two layers, it is preferable that an electron-transporting layer material whose electron-mobility is higher is located nearer to electron-injecting layer (34) whilst an electron-transporting layer material whose electron-mobility is lower is located nearer to blue light-emitting layer (320). This results in said electron-transporting layer material, whose electron-mobility is lower, serving as a buffer thereby reducing the above interaction between said electron-transporting layer material whose electron-mobility is higher and said blue light-emitting layer material, with keeping the light-emitting efficiency and with elongating lifetime. In these cases, the thickness of the layer consisting of said electron-transporting material whose electron-mobility is lower is preferably set to be 0.1-2 times as thick as that of the layer consisting of said electron-transporting material whose electron-mobility is higher.

Said electron-transporting layer material whose electron-mobility is lower can be metal phenolates, metal-quinolinolate complexes, triazole derivatives, oxazole derivatives, oxadiazole derivatives, quinoxaline derivatives, quinoline derivatives, pyrrole derivatives, benzopyrrole derivatives, tetraphenylmethane derivatives, pyrazole derivatives, thiazole derivatives, benzothiazole derivatives, thiadiazole derivatives, thionaphthene derivatives, spiro-compounds, imidazole derivatives, benzimidazole derivatives, distyrylbenzene derivatives, etc. Amongst these, in particular, aluminum tris(8-quinolinolate) and aluminum bis(2-methyl-8-quinolinolate) (p-phenylphenolate) are preferable. Said electron-transporting layer material whose electron-mobility is higher can be phenanthroline derivatives, triazole derivatives, oxazole derivatives, oxadiazole derivatives, quinoxaline derivatives, silole derivatives, quinoline derivatives, pyrrole derivatives, benzopyrrole derivatives, tetraphenylmethane derivatives, pyrazole derivatives, thiazole derivatives, triphenylmethane derivatives, benzothiazole derivatives, thiadiazole derivatives, thionaphthene derivatives, spiro-compounds, imidazole derivatives, benzimidazole derivatives, distyrylbenzene derivatives, etc. Amongst these, 2,9-dimethyl-4,7-diphenylphenanthroline is preferable. These materials can suitably be used alone or in combination.

Electron-transporting layer (54) can be prepared with the above material(s) by a known film-forming method such as a sputtering method, an ion-plating method, a vacuum-vapor-deposition method, a spin-coating method, an electron-beam vapor-deposition method, etc. on blue light-emitting layer (320).

### << Electron-injecting layer (34) >>

Electron-injecting layer (34) is laminated between cathode (15) and electron-transporting layer (54). Electron-injecting layer (34) forms a cathode-interfacing layer and facilitates injection of electrons from cathode (15) into electron-transporting layer (54). The thickness of electron-injecting layer (34) is preferably 0.1 nm-3 nm, more preferably 0.2 nm-1 nm.

Materials to be used in electron-injecting layer (34) can be any materials giving the above properties to electron-injecting layer (34) and are for example alkali metals such as lithium, sodium, cesium, etc., alkali earth metals such as strontium, magnesium, calcium, etc., alkali metal compounds and alkali earth metal fluorides, oxides, chlorides, sulphides, etc such as lithium fluoride, lithium oxide, magnesium fluoride, calcium fluoride, strontium fluoride, barium fluoride, etc. Amongst these, lithium fluoride is preferable. Electron-injecting layer (34) may be made of only one of these materials or of a plurality of these materials.

Electron-injecting layer (34) can be prepared with these materials by a known film-forming method such as a sputtering method, an ion-plating method, a vacuum-vapor-deposition method, a spin-coating method, an electron-beam vapor-deposition method, etc. on electron-transporting layer (54).

### << Cathode (15) >>

Cathode (15) is an electrode to inject electrons into electron-injecting layer (34). Metals, alloys, electrically conductive compounds, and mixtures thereof whose work function for example is less than 4.5 eV are used in order to improve electron-injecting efficiency.

Such cathode materials are for example lithium, sodium, magnesium, silver, copper, aluminum, indium, calcium, tin, ruthenium, titanium, manganese, chromium, yttrium, aluminum-calcium alloys, aluminum-lithium alloys, aluminum-magnesium alloys, magnesium-silver alloys, magnesium-indium alloys, lithium-indium alloys, sodium-potassium alloys, magnesium/copper mixtures, aluminum/aluminum oxide mixtures, etc. The above anode materials can also be used in cathode (15). Amongst these materials, aluminum is preferable.

When cathode (15) is located on the light-emitting surface side relatively to red light-emitting layer (321) and to blue light-emitting layer (320), cathode (15) should in general be of transparency of more than 10 % to lights to be emitted. For example, electrodes formed by lamination of a transparent conductive oxide with a very thin film of a magnesium-silver alloy are used. Upon sputtering a conductive oxide in cathode (15), in order to prevent light-emitting layers etc. from being damaged with plasma, a buffering layer into which copper-phthalocyanine etc. is added may be laminated between cathode (15) and electron-injecting layer (34).

When cathode (15) is used as a light-reflective electrode, materials reflective to lights to be emitted are selected suitably from the above materials. In general, metals, alloys, and metal compounds are selected.

Cathode (15) may be formed with only one of the above materials or with a plurality of them. For example, addition of 1-20 weight % of silver or copper to magnesium, addition of 0.1-10 weight % of lithium to aluminum, etc. can prevent cathode (15) from oxidation and can improve adhesion of cathode (15) with electron-injecting layer (34).

Cathode (15) may consist of a plurality of identical or different composition layers. For example, the following structure may be made.
i) In order to prevent cathode (15) from oxidation, a protective layer made of a corrosion-resistant metal is formed in or on part of cathode (15) not contacting with electron-injecting layer (34).

As materials for the protective layer, for example, silver, aluminum, etc. are used preferably.

Cathode (15) can be formed by a known thin film-forming method such as a vacuum-vapor-deposition method, a sputtering method, an ionization vapor-deposition method, an ion-plating method, an electron-beam vapor-deposition method, etc. on electron-injecting layer (34) or on the protective layer.

The thickness of cathode (15), not including that of the protective layer, is set to be generally around 5 nm-1 µm, preferably around 5 nm-700 nm, especially preferably around 10 nm-500 nm, and most desirably 50 nm-200 nm, although depending upon electrode materials actually used.

Electric resistance per sheet of cathode (15) is set preferably to be several hundreds Ω/sheet or less.

Thus, the present organic EL devices according to the second embodiment have only to have any one of constructions (9)-(13) and can be modified suitably in other points.
(9) On an anode, at least a hole-transporting layer, an organic light-emitting layer, and then a cathode in this order are laminated, said organic light-emitting layer consisting of a lamination of a red light-emitting layer and then a blue light-emitting layer in this order from said hole-transporting layer side, and said red light-emitting layer containing a green dopant.
(10) In above (9), an emission-adjusting layer is laminated between said red light-emitting layer and said blue light-emitting layer.
(11) In above (9) or (10), said blue light-emitting layer is thicker than that of said red light-emitting layer.
(12) In any one of above (9)-(11), said red light-emitting layer contains a hole-transporting material, a red dopant, and a green dopant.
(13) In any one of above (9)-(12), the hole-mobility of said red light-emitting layer is greater than that of said blue light-emitting layer.
(14) In any one of above (9)-(13), said blue light-emitting layer contains at least one blue dopant(s) selected from the group consisting of distyrylamine derivatives, pyrenes, perylenes, anthracenes, benzoxazoles, benzothiazoles, benzimidazoles, chrysenes, phenanthrenes, distyrylbenzenes, and tetraarylbutadienes and at least one bipolar host(s) selected from the group consisting of distyryl arylenes, stilbenes, carbazole derivatives, triarylamines, aluminum bis(2-methyl-8-quinolinolate)(*p*-phenylphenolate), and 4,4'-bis(2,2-diphenylvinyl)biphenyl.

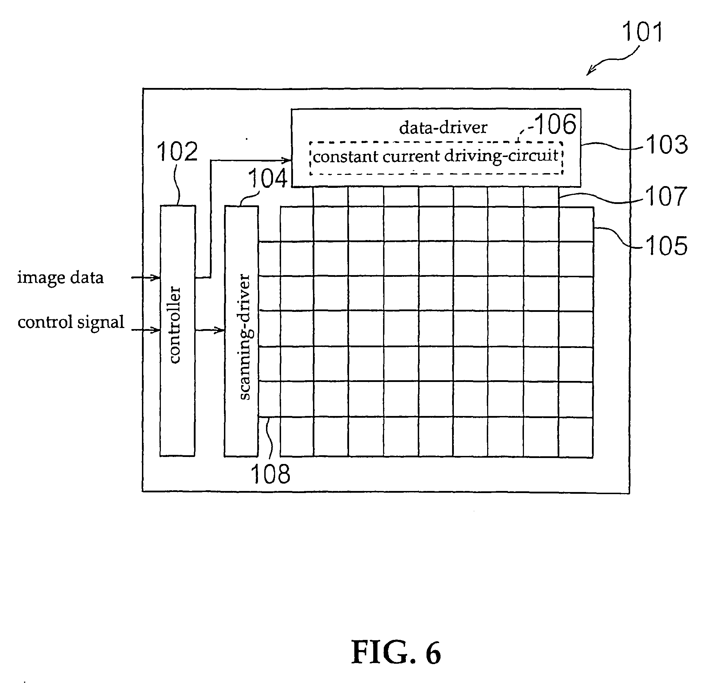

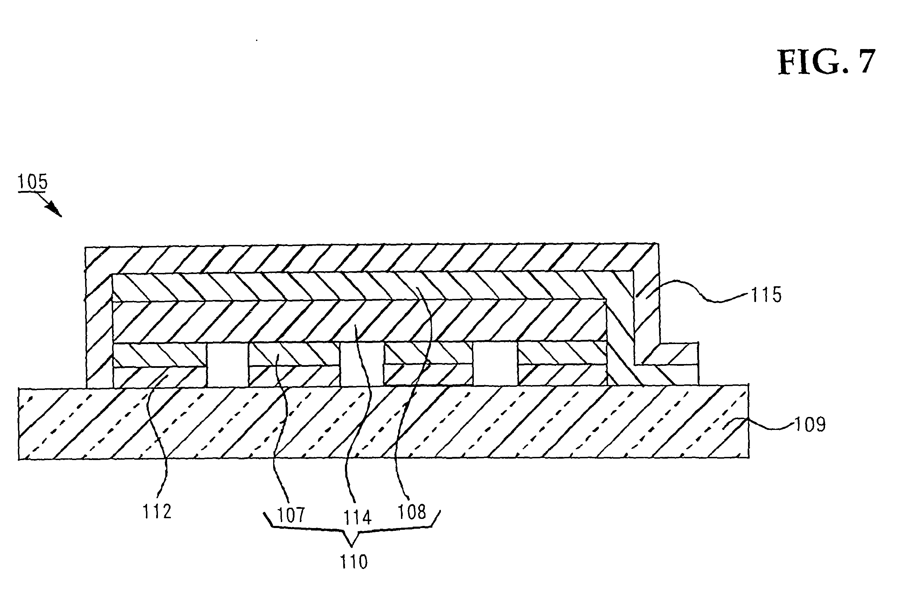

Color displays using the above organic EL devices are illustrated in Fig. 6 and Fig. 7.

Figure 6 is an outlined overall construction view of color display (101). Color display (101) consists of controller (102), data-driver (103), scanning-driver (104), and organic EL panel (105).

Controller (102) of color display (101) is connected with data-driver (103) and with scanning-driver (104). Based upon input data to be displayed and control signals, controller (102) outputs display signals, which are scanning signals, to display the data on organic EL panel (105) into data-driver (103) and into scanning-driver (104).

Data-driver (103) is connected with anode (107) formed on organic EL panel (105) whilst scanning-driver (104) is connected with cathode (108) formed on organic EL panel (105). Data-driver (103) involves constant-current driving-circuit (106).

Organic EL panel (105) will now be set forth. Figure 7 is a model cross-sectional figure of organic EL panel (105) along cathode (108). As illustrated in Fig. 7, organic EL panel (105) has transparent substrate (109), organic EL device (110) formed on the surface of transparent substrate (109), and color filter (CF, 112) between transparent substrate (109) and organic EL device (110).

Based upon display signals, data-driver (103) switches to allow pixels of organic EL panel (105) to be light-emitting and supplies current corresponding to the display signals to organic EL device (110) via anode (107) by constant-current driving-circuit (106). Scanning-driver (104) connects cathode (108) corresponding to the display signal with a constant electric source, for example, ground thereby injecting current corresponding to brightness of the display data to be displayed on organic EL device (110).

Color filter (112) is located away from but corresponding to organic EL device (110) and the light-emitting surface is on the side of cover plate (111).

Cover plate (111) is fixed onto the substrate via sealant (113). Organic EL device (110) is surrounded by substrate (109), sealant (113), and cover plate (111).

As organic EL device (110), the present organic EL device according to the second embodiment can be used. Organic EL device (110) except for its surface facing substrate (109) is coated with passivation film (115). Passivation film (115) is formed with a waterproofing material.

A plurality of parallel stripes of anodes (107) are formed on the surface of substrate (109). Anodes (107) in Fig. 7 are formed perpendicularly extending relatively to the figure. A plurality of parallel stripes of organic EL layers (114) are formed perpendicularly extending relatively to anodes (107).

Cathode (108) is laminated on the formed stripes of organic EL layers (114) and is formed perpendicularly relatively to anodes (107). A matrix of pixels of organic EL device (110) is located at crossing points of anode (107) and cathode (108) on substrate (109). Cathode (108) is formed transparent in order to allow emission from organic EL layers (114) to be transmittable.

Red light-emission (R), green light-emission (G), and blue light-emission (B) of organic EL device (110) have light-emitting peak wave length within 580 nm-680 nm and half-width of 10 nm-140 nm, light-emitting peak wave length within 510 nm-550 nm and half-width of 10 nm-140 nm, and light-emitting peak wave length within 440 nm-490 nm and half-width of 10 nm-140 nm, respectively.

Red pixels (R), green pixels (G), and blue pixels (B), not shown, of color filter (112) have transmission peak wave length of 560 nm or longer, transmission peak wave length within 510 nm-550 nm and half-width of 140 nm or less e.g. 80 nm-140 nm, and transmission peak wave length within 450 nm-490 nm and half-width of 140 nm or less e.g. 80 nm-140 nm, respectively.

The emission region, of organic EL device (110), within the half-width from the light-emitting peak wave length of organic EL device (110) as the center is included in the transmission region, of color filter (112), within the half-width from the transmission peak wave length of color filter (112) as the center. Proviso that "560 nm or longer" of the transmission peak wave length of red (R) pixels of color filter (112) means that it can include any lights of a longer wave length than 560 nm. This is because they have a lower energy than the light of 560 nm wave length has. Since only the lower limitation of the wave length thus is set, no half-width is especially set.

Operation of color display (101) above mentioned will now be set forth. Based upon input display data and control signals, controller (102) outputs display signals into data-driver (103) and into scanning-driver (104). Based upon the display signals output from controller (102), constant-current driving-circuit (106) injects current corresponding to the display data into between anode (107) and cathode (108) of parts to be allowed to emit lights. The white light emitted by the injected current is outgone form the side of cover plate (111) through color filter (112). After passing of the white light through red (R), green (G), or blue (B) pixels of color filter (112), the corresponding color lights are obtained. Combination of the red (R), green (G), and blue (B) pixels re-produces the desired colors.

The emission property of organic EL device (110) and the transmission property of color filter (112) within the above ranges can efficiently achieve beautiful color emissions since the respective ranges of the emission wave lengths are included within those of the transmission wave lengths.

Further, in the above embodiment, an inorganic or organic color filter may be used as color filter (112). In the above embodiment, although color display (101) has been embodied in a passive-matrix manner, color display (101) may be embodied in an active-matrix manner with the switching function either on the anode side or on the cathode side.

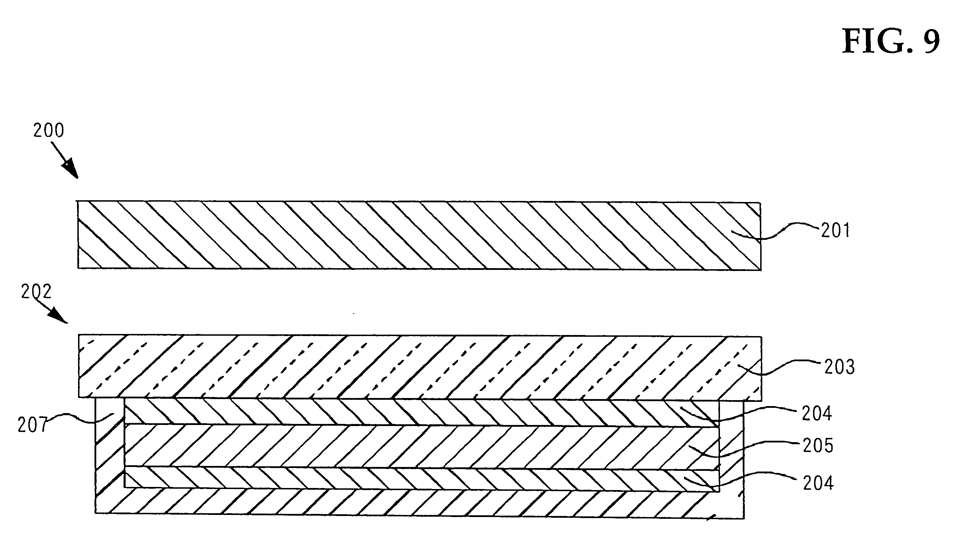

A liquid crystal display using the above organic EL device as a backlight will now be set forth. As illustrated in Fig. 9, liquid crystal display (200) consists of liquid crystal panel (201) and backlight (202). Liquid crystal panel (201) is a known one and has a plurality of pixels, corresponding to each of which red (R), green (G), and blue (B) color filters are set but not shown. By adjustment of the voltage applied to the electrodes countering each other across the liquid crystal, the amounts of lights to be passed through each pixel are adjusted. The properties of color filters (R, G, and B) are preferably transmission peak wave length of 560 nm or longer, transmission peak wave length within 510 nm-550 nm and half-width of 140 nm or less e.g. 80 nm-140 nm, and transmission peak wave length within 450 nm-490 nm and half-width of 140 nm or less e.g. 80 nm-140 nm, respectively.

Backlight (202) is constructed with the present organic EL device according to the second embodiment. In the present organic EL device constructing backlight (202), a transparent electrode, that is anode (204), organic layer (205), and a metallic electrode, that is cathode (206), in this order downward in Fig. 9 are laminated on transparent substrate (203). The passivation film (207) is formed outside to protect the electrodes and the organic compounds of the present organic EL device from humidity and/or oxygen outside.

Anode (204), organic layer (205), and cathode (206) are formed so that all of them have almost the same size as the substrate. Current from anode (204) to cathode (206) allows the whole device simultaneously to emit lights.

Organic layer (205), as described in the second embodiment, has at least a red light-emitting layer and a blue light-emitting layer, said red light-emitting layer containing a green dopant. Thus, organic layer (205) emits a white light upon current injected. The emission has properties of light-emitting peak wave length within 580 nm-680 nm and half-width of 10 nm-140 nm, light-emitting peak wave length within 510 nm-550 nm and half-width of 10 nm-140 nm, and of light-emitting peak wave length within 440 nm-490 nm and half-width of 10 nm-140 nm.

Operation of liquid-crystal display (200) thus constructed will be set forth. Into liquid-crystal panel (201), signals from a liquid crystal panel-driving device not shown are input. According to the signals, transmittance of lights at each pixel of liquid-crystal panel (201) is determined. Simultaneously, current is injected from anode (204) to cathode (206) of backlight (202) and it emits a white light. The light from backlight (202) incomes into liquid crystal panel (201), through each pixel and the color filters, and then reaches observer's eyes. At this time at the pixels of liquid crystal panel (201), quantity of the lights to be transmitted is adjusted and further by the colour filters, the wave length region of the lights to be transmitted are limited. By the whole liquid crystal display, desired images etc. thus are represented.

Also in liquid crystal display (200), the transmission property of the color filters of liquid crystal panel (201) and the emission property of the organic EL devices constructing backlight (202) within the above ranges can efficiently achieve beautiful color emissions because the respective ranges of wave lengths of emitted lights are within those of transmitted lights.

### EXAMPLES

Hereinafter, examples of the present invention and comparative examples will be described. However, the present invention naturally should not be limited to the following examples.

### < Example 1 >

Transparent glass substrate (1), on one of whose surfaces anode (10) made of an ITO layer of 250 nm thickness had been formed, was washed with an alkali and then with a pure water, dried, and then cleaned with UV-ozone.

On anode (2) thus washed and cleaned, using a vacuum vapor deposition apparatus (a carbon crucible, at a vapor deposition speed of 0.1 nm/s, under a vacuum around 5.0 x 10 ⁻⁵ Pa), an layer of 50 nm thickness of *N*,*N*'-bis(4'-diphenylamino-4-biphenylyl)-*N*,*N*-diphenylbenzidine of the following formula (1) was prepared to be hole-injecting-transporting layer (11).

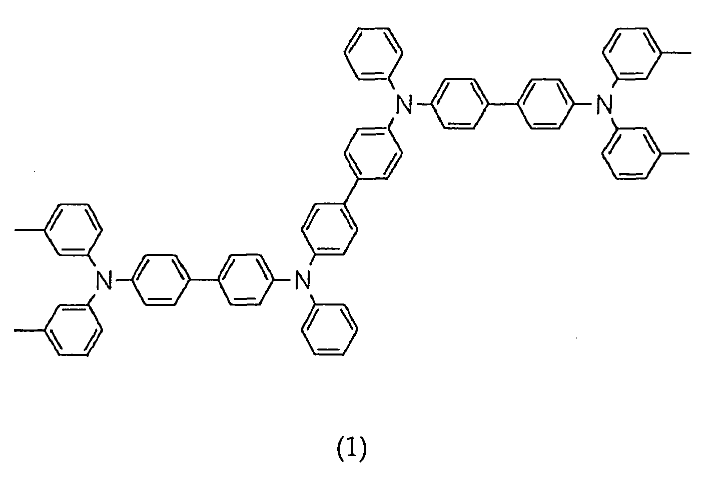

On hole-injecting-transporting layer (11), using a vacuum vapor deposition apparatus (a carbon crucible, at a vapor deposition speed of 0.1 nm/s, *in vacuo* around 5.0 x 10⁻⁵ Pa), a co-deposited layer of 30 nm thickness of 93.0 weight % of 4,4'-bis(2,2'-diphenylvinyl)biphenyl of the following formula (2) and 7.0 weight % of 4,4'-[bis(9-ethyl-3-carbazovinylene)-1,1'-biphenyl of the following formula (3) was prepared to be light-emitting layer (12).

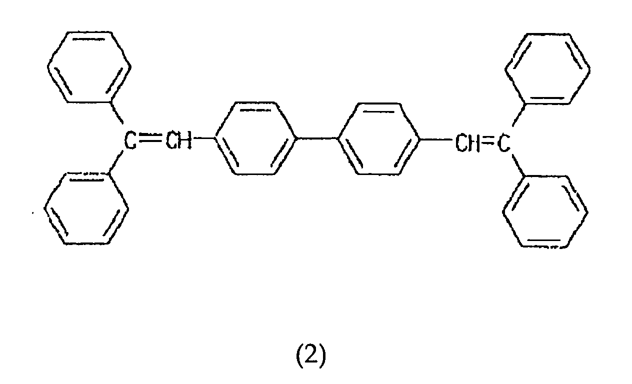

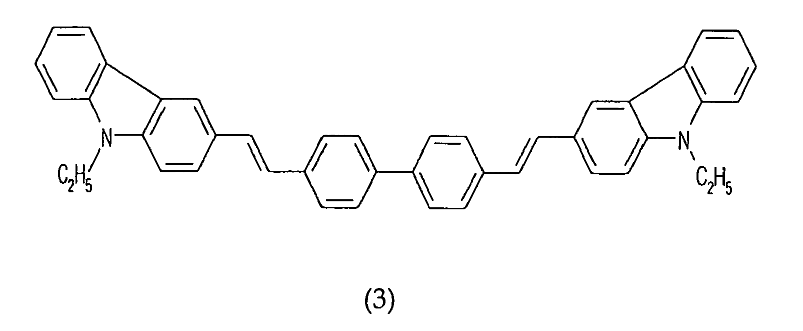

On light-emitting layer (12), using a vacuum vapor deposition apparatus (a carbon crucible, at a vapor deposition speed of 0.1 nm/s, *in vacuo* around 5.0 x 10⁻⁵ Pa), a co-deposited layer of 5 nm thickness of 37 weight % of aluminum tris(8-quinolinolate) of the following formula (4) and 63 weight % of 4,4'-bis(2,2'-diphenylvinyl)biphenyl of the above formula (2) was prepared to be non-light-emitting layer (13).

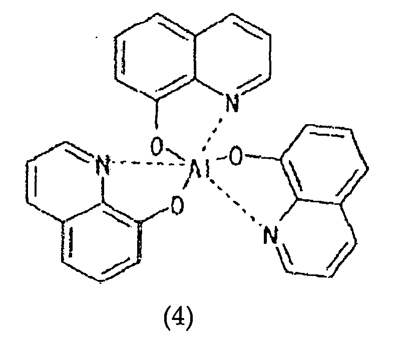

On non-light-emitting layer (13), using a vacuum vapor deposition apparatus (a carbon crucible, at a vapor deposition speed of 0.1 nm/s, *in vacuo* around 5.0 x 10 ⁻⁵ Pa), a layer of 15 nm thickness of 2,5-bis[6'-(2',2"-bipyridyl)]-1,1-dimethyl-3,4-diphenylsilole of the following formula (5) was prepared to be electron-injecting-transporting layer (14).

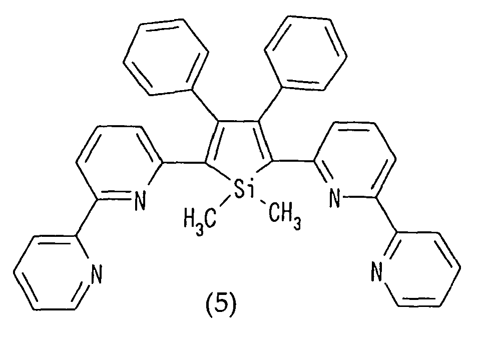

On electron-injecting-transporting layer (14), using a vacuum vapor deposition apparatus (a carbon crucible, at a vapor deposition speed of 0.1 nm/s, *in vacuo* around 5.0 x 10 ⁻⁵ Pa), a lithium fluoride (LiF) layer of 0.5 nm thickness was formed to be a cathode-interfacing layer.

On electron-injecting-transporting layer (14), using a tungsten boat (at a vapor deposition speed of 1 nm/s, *in vacuo* around 5.0 x 10 ⁻⁵ Pa), an aluminum (Al) layer of 150 nm thickness was formed to be cathode (15). Finally, an organic EL device according to the present invention was prepared.

The organic EL device thus prepared was capped with glass. Anode (10) and cathode (15) were connected with a known driving circuit. Electric power efficiency (lm/W) at 1,600 cd/m² brightness was measured. With a continuous current, half-life of the initial brightness (hr) was also measured, which was a time in which the brightness decreased from initial 4,800 cd/m² till 2,400 cd/m². The brightness was measured by trade name BM7, Topcon K.K. The results obtained are shown in Table 1.

### < Comparative Example 1 >

Similarly to in example 1, except that non-light-emitting layer 13 was absent, an organic EL device of comparative example 1 was prepared. Its electric power efficiency and half-life of the initial brightness were measured similarly to in example 1. The results obtained are shown in Table 1.

### < Examples 2-6 >

Examples 2-6 were prepared similarly to in example 1 except that 9 weight % of, 15 weight % of, 40 weight % of, 50 weight % of, and 65 weight % of aluminum tris(8-quinolinolate), respectively, were contained in their non-light-emitting layer. Their electric power efficiency and half-life of the initial brightness were measured similarly to in example 1. The results obtained are shown in Table 1.

### < Examples 7 and 8 >

Examples 7 and 8 were prepared similarly to in example 1 except that light-emitting layer (12) was of 30 nm thickness and that non-light-emitting layer (13) was of 25 nm and of 20 nm thickness, respectively. Electric power efficiency and half-life of the initial brightness of the organic EL devices prepared were measured similarly to in example 1. The results obtained are shown in Table 2.

### < Example 9 >

Example 9 was prepared similarly to in example 1 except that non-light-emitting layer 13 was made of 2,5-bis[6'-(2',2"-bipyridyl)]-1,1-dimethyl-3,4-diphenylsilole of the above formula (5) instead of aluminum tris(8-quinolinolate). Electric power efficiency and half-life of the initial brightness of the organic EL device prepared were measured similarly to in example 1. The results obtained are shown in Table 3.

**Table 1: Doping amounts of Alq3, electric power efficiency, and half-life**

| | doping amounts of Alq3 (weight %) | electric power efficiency (lm/W) | half-life (hr) |
|---|---|---|---|
| Example 1 | 37 | 9.61 | 238 |
| Example 2 | 9 | 10.02 | 125 |
| Example 3 | 15 | 9.61 | 133 |
| Example 4 | 40 | 8.89 | 220 |
| Example 5 | 50 | 8.14 | 300 |
| Example 6 | 65 | 7.67 | 350 |
| Comparative Example 1 | 0 | 10.4 | 67 |

**Table 2: Thickness of non-light-emitting layer (13), electric power efficiency, and half-life**

| | thickness of non-light-emitting layer (13) (nm) | electric power efficiency (1m/W) | half-life (hr) |
|---|---|---|---|
| Example 4 | 5 | 8.89 | 220 |
| Example 7 | 15 | 8.30 | 243 |
| Example 8 | 30 | 8.01 | 275 |
| Comparative Example 1 | 0 | 10.4 | 67 |

**Table 3: Materials contained in non-light-emitting layer (13), electric power efficiency, and half-life**

| | dopants of the non-light-emitting layer | electric power efficiency (1m/W) | half-life (hr) |
|---|---|---|---|
| Example 1 | 37 weight % of Alq3 | 9.61 | 238 |
| Example 9 | 37 weight % of (5) | 10.9 | 146 |
| Comparative Example 1 | none | 10.4 | 67 |

In all the examples, electron-mobility and hole-mobility of non-light-emitting layer (13) and of electron-injecting-transporting layer (14) were measured by TOF method. The results showed that non-light-emitting layer (13) had an electron-transporting property and a stronger hole-transporting property than electron-injecting-transporting layer (14) had. As the spectra of the organic EL devices prepared were measured by trade name BM7, Topcon K.K, no emission or its peak wave length from the materials contained in non-light-emitting layer (13) was observed.

### < Evaluations >

As can be seen from examples 1-9 and comparative example 1, non-light-emitting layer (13) was found to elongate half-life of the initial brightness with little change in electric power efficiency compared to without non-light-emitting layer (13).

As can be seen from examples 1-6 and comparative example 1, as hole-mobility of non-light-emitting layer (13) increased, half-life of the initial brightness became longer with little change in electric power efficiency. In non-light-emitting layer (13) of example 6, its electron-transporting property was stronger than its hole-transporting property as measured by TOF method.

Measurements of electron-mobility and hole-mobility of aluminum tris(8-quinolinolate) by TOF method demonstrated that aluminum tris(8-quinolinolate) had an electron-transporting property and a stronger hole-transporting property than the electron-injecting-transporting layer had. As can be seen from this result, examples 1-8, and comparative example 1, it was found to be good for non-light-emitting layer (13) to contain a material having an electron-transporting property and having a stronger hole-transporting property than the electron-injecting-transporting layer has.

As can be seen from example 9 and comparative example 1, even when non-light-emitting layer (13) contains both a material contained in the electron-injecting-transporting layer and a hole-transporting material, the desired effects of the present invention can be obtained.

As can be seen from examples 1-8 and comparative example 1, even when a host contained in light-emitting layer (12) is used as a hole-transporting material, the desired effects of the present invention can be obtained.

As can be seen from examples 4, 7, 8, and comparative example 1, thicker non-light-emitting layer 13 was found to give a longer half-life of the initial brightness.

### < Example 10 >

Transparent glass substrate (2), on one of whose surfaces anode (10) made of an ITO layer of 170 nm thickness had been formed, was prepared and washed with an alkali and then with a pure water, dried, and then cleaned with excimer-UV.

On anode (10), using a vacuum vapor deposition apparatus (a carbon crucible, at a vapor deposition speed of 0.1 nm/s, under a vacuum around 5.0 x 10 ⁻⁵ Pa), an layer of 10 nm thickness of tris[4-[*N*-(3-methylphenyl)-N-phenylamino]phenyl]amine was prepared to be hole-injecting layer (31).

On hole-injecting layer (31), using a vacuum vapor deposition apparatus (a carbon crucible, at a vapor deposition speed of 0.1 nm/s, *in vacuo* around 5.0 x 10 ⁻⁵ Pa), a layer of 70 nm thickness of 4,4'-bis[*N*-(1-naphthyl)-*N*-phenylamino]biphenyl vapor-deposited was prepared to be hole-transporting layer (51).

On hole-transporting layer (51), using a vacuum vapor deposition apparatus (a carbon crucible, at a vapor deposition speed of 0.1 nm/s, *in vacuo* around 5.0 × 10⁻⁵ Pa), a co-deposited layer of 5 nm thickness of a host of the red light-emitting layer 4,4'-bis[*N*-(1-naphthyl)-*N*-phenylamino]biphenyl, a red dopant [2-*tert*-butyl-6-[*trans*-2-(2,3,5,6-tetrahydro-1,1,7,7-tetramethylbenzo[i,j]quinolidin-9-yl)ethenyl]-4H-pyran-4-ylidene]-1,3-propanedinitrile (0.5 weight %), and a green dopant *N*,*N*'-dimethylquinacridone (1 weight %) was prepared to be red light-emitting layer (321).

On red light-emitting layer (321), using a vacuum vapor deposition apparatus (a carbon crucible, at a vapor deposition speed of 0.1 nm/s, *in vacuo* around 5.0 × 10⁻⁵ Pa), a co-deposited layer of 25 nm thickness of a host of the blue light-emitting layer 4,4'-bis(2,2'-diphenylvinyl)biphenyl and of a blue dopant 4,4'-bis[2-(*N*-ethylcarbazol-2-yl)vinyl]biphenyl (3 weight %) was prepared to be blue light-emitting layer (320).

Hole-mobility of the red light-emitting layer was measured to be greater than that of the blue light-emitting layer.

Measurements of hole-mobility and electron-mobility of 4,4'-bis(2,2'-diphenylvinyl)biphenyl revealed that it is a bipolar material.

On blue light-emitting layer (320), using a vacuum vapor deposition apparatus (a carbon crucible, at a vapor deposition speed of 0.1 nm/s, *in vacuo* around 5.0 x 10⁻⁵ Pa), a layer of 15 nm thickness of aluminum tris(8-quinolinolate) was formed to be electron-transporting layer (54).

On electron-transporting layer (54), using a vacuum vapor deposition apparatus (a carbon crucible, at a vapor deposition speed of 0.1 nm/s, *in vacuo* around 5.0 x 10 ⁻⁵Pa), a lithium fluoride (LiF) layer of 0.5 nm thickness was formed to be electron-injecting layer (34).

On electron-injecting layer (34), using a tungsten boat (at a vapor deposition speed of 1 nm/s, *in vacuo* around 5.0 x 10⁻⁵ Pa), an aluminum (Al) layer of 100 nm thickness was formed to be cathode (15). Finally, an organic EL device according to the present invention was prepared.

The organic EL device thus prepared was capped with glass. Chromaticity coordinates of emitted lights and light-emitting efficiency (lm/W) at 1,600 cd/m² brightness, half-life of the initial brightness under a continuous current which half-life was a time in which brightness decreased from initial 4,800 cd/m² till 2,400 cd/m², and changes in chromaticity of this organic EL device were measured. The brightness was measured by trade name BM7, Topcon K.K. The changes in chromaticity were defined as a square root of (variation in chromaticity x)² + (variation in chromaticity y)². Further, variation in chromaticity is a difference between the initial chromaticity and the chromaticity upon brightness having been half decreased. The results obtained etc. are shown in Table 4.

The light-emitting spectrum of this device had local maximum points in ranges of 440 nm-490 nm, 510 nm-550 nm, and of 580 nm-680 nm as measured by trade name SR-2, Topcon K.K.

### < Examples 11-32 >

Also in examples 11-32, substrate (2), anode (10), hole-transporting layer (51), blue light-emitting layer (320), electron-injecting layer (34), and cathode (15) were formed similarly to in example 10.

The other layers were formed with the materials summarized in Tables 4 and 5 shown below. The abbreviation numbers in these tables are as follows.
1: aluminum tris(8-quinolinolate)
2: 4,4'-bis(2,2'-diphenylvinyl)biphenyl
3: 4,4'-bis[2-(*N*-ethylcarbazol-2-yl)vinyl]biphenyl
4: 4,4'-bis[*N*-(1-naphthyl)-*N*-phenylamino]biphenyl
5: [2-*tert*-butyl-6-[*trans*-2-(2,3,5,6-tetrahydro-1,1,7,7-tetramethylbenzo[i,j]quinolidin-9-yl)ethenyl]-4H-pyran-4-ylidene]-1,3-propanedinitrile
6: *N*,*N*'-dimethylquinacridone
7: tris[4-[*N*-(3-methylphenyl)-*N*-phenylamino]phenyl]amine
8: 2,9-dimethyl-4,7-diphenylphenanthroline
9: 4,4'-bis[*N*-(3-methylphenyl)-*N*-phenylamino]biphenyl
10: 7-diethylaminobenzo[a]phenoxadin-9H-3-one
11: *cis*-2-(1,3-benzothiazol-2-yl)-3-(8-hydroxy-2,3,5,6-tetrahydro-1,1,7,7-tetramethylbenzo[i,j]quinolidin-9-yl)acrylic acid lactone
12: tris[4-[*N*-(2-naphthyl)-*N*-phenylamino]phenyl]amine
13: dibenzo[c,n]quinacridone
14: porphyrin-copper(II) complex
15: [2-methyl-6-[*trans*-2-(2,3,5,6-tetrahydro-1,1,7,7-tetramethylbenzo[i,j]quinolidin-9-yl)ethenyl]-4H-pyran-4-ylidene]-1,3-propanedinitrile
16: 3-(1,3-benzothiazol-2-yl)-7-diethylaminocoumarin
17: dibenzo[f,g:s,t]pentacene
18: 7'-aza-8'-cyclohexyl-9-thiaanthro[10a,10-a:9,9a-m:5,10a-1]-anthracen-10-one
19: dibenzotetraphenylperiflanthene
20: anthro[7,6-o:6,5a-p:5a,5-q:5,4a-r:4a,4-s]tetracene
21: dinaphtho[2,1-d:1,8a-e:8a,8-f:8,7-g][4,3-j]anthracene
22: dibenzo[d,e:u,v]pentacene

Electron-transporting layer (54) only in example 11 consisted of two layers one nearer to the cathode of which was 7.5 nm thickness of 2,9-dimethyl-4,7-diphenylphenanthroline (8) and the other of which was 7.5 nm thickness of aluminum tris(8-quinolinolate) (1). In examples 12-32, electron-transporting layer (54) was formed similarly to in example 10.

Hole-mobility of the red light-emitting layer in examples 11-32 was measured to be greater than that of the blue light-emitting layer in examples 11-32.

An emission-adjusting layer was formed to be of 1 nm thickness of 4,4'-bis[*N*-(1-naphthyl)-*N*-phenylamino]biphenyl (4) by vapor deposition between red light-emitting layer (321) and blue light-emitting layer (320) in examples 11, 12, 14, 16, 18, 20, 22, 24, 26, and 28.

Red light-emitting layer (321) and hole-injecting layer (31), as shown in Tables 4 and 5 below, were formed with a variety of materials by vapor deposition. The host contained in red light-emitting layer (321) was 4,4'-bis[*N*-(3-methylphenyl)-*N*-phenylamino]biphenyl (9) only in example 12 and 4,4'-bis[*N*-(1-naphthyl)-*N*-phenylamino]biphenyl (4) in examples 11 and 13-32 similarly to in example 10.

Similarly to in example 10, of emission from the organic EL devices thus prepared in examples 11-32, chromaticity coordinates of emission and light-emitting efficiency (lm/W) at 1,600 cd/m² brightness, half-life of the initial brightness set at 4,800 cd/m² under a continuous current which was a time in which the brightness decreased from 4,800 cd/m² till 2,400 cd/m², and changes in chromaticity were measured. The brightness was measured by trade name BM7, Topcon K.K. The changes in chromaticity were defined as a square root of (variation in chromaticity x)² + (variation in chromaticity y)². Further, variation in chromaticity is a difference between the initial chromaticity and the chromaticity upon the brightness having been half decreased. The results obtained etc. are shown in Tables 4 and 5.

The light-emitting spectra of these devices had local maximum points in ranges of 440 nm-490 nm, 510 nm-550 nm, and of 580 nm-680 nm as measured by trade name SR-2, Topcon K.K.

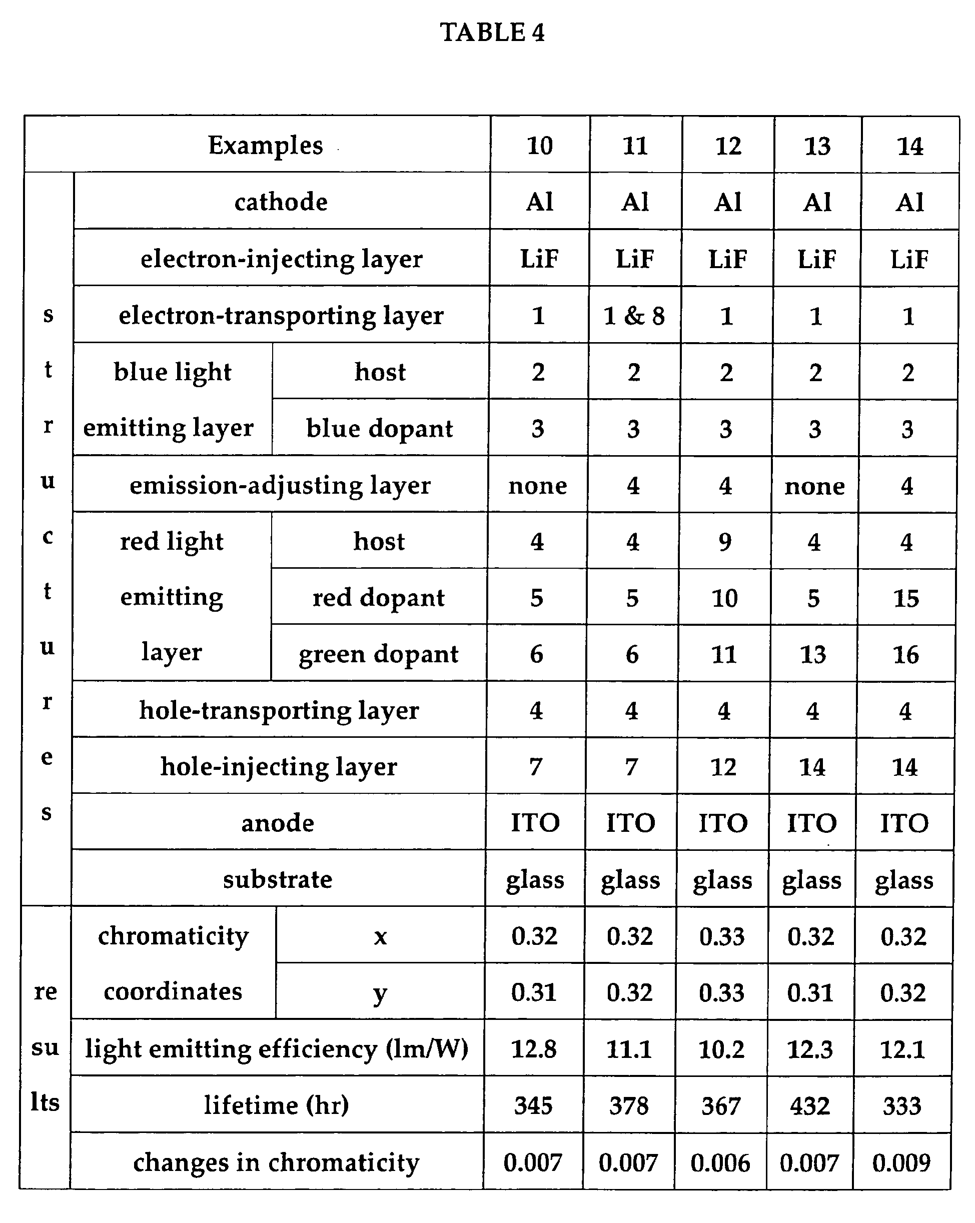

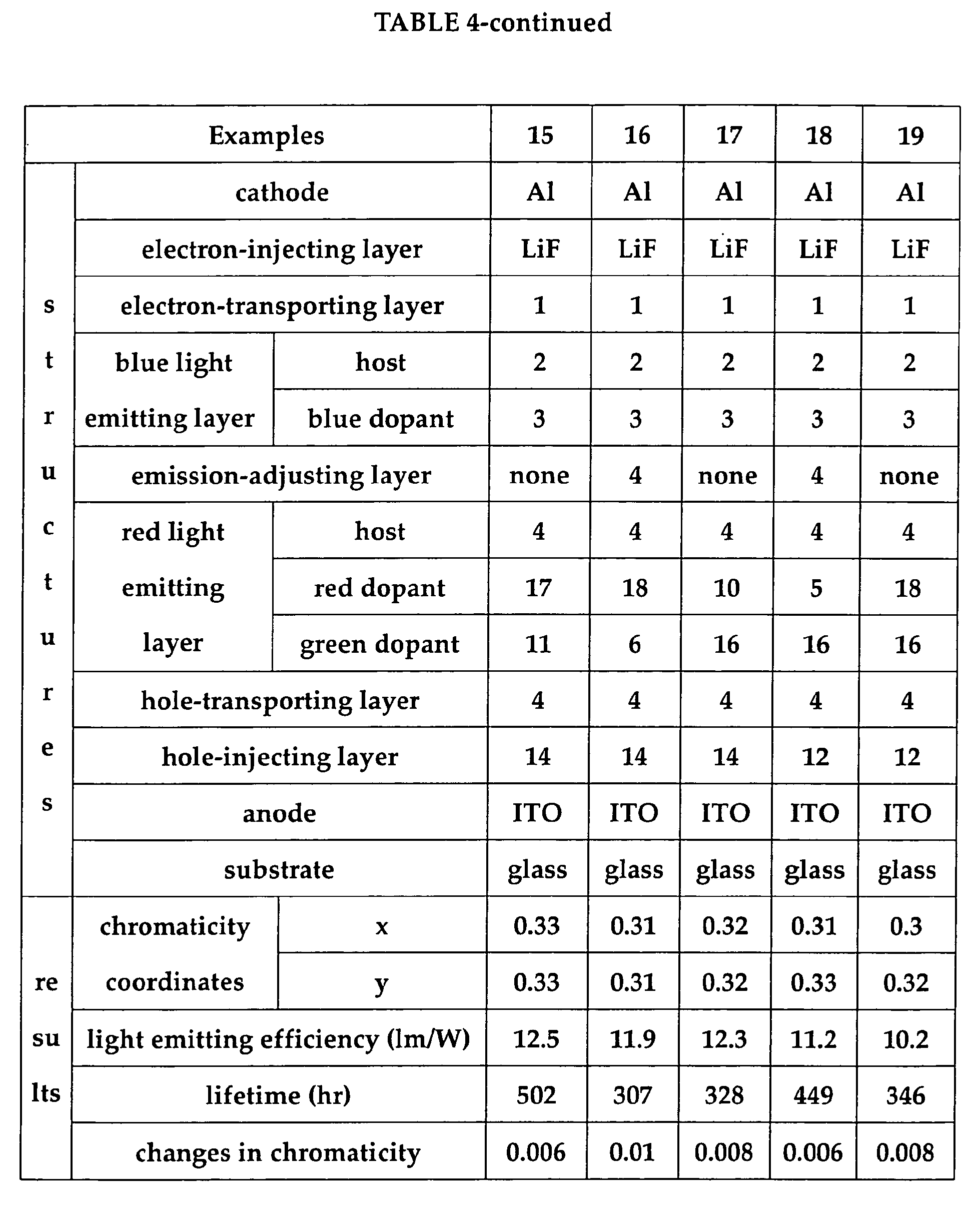

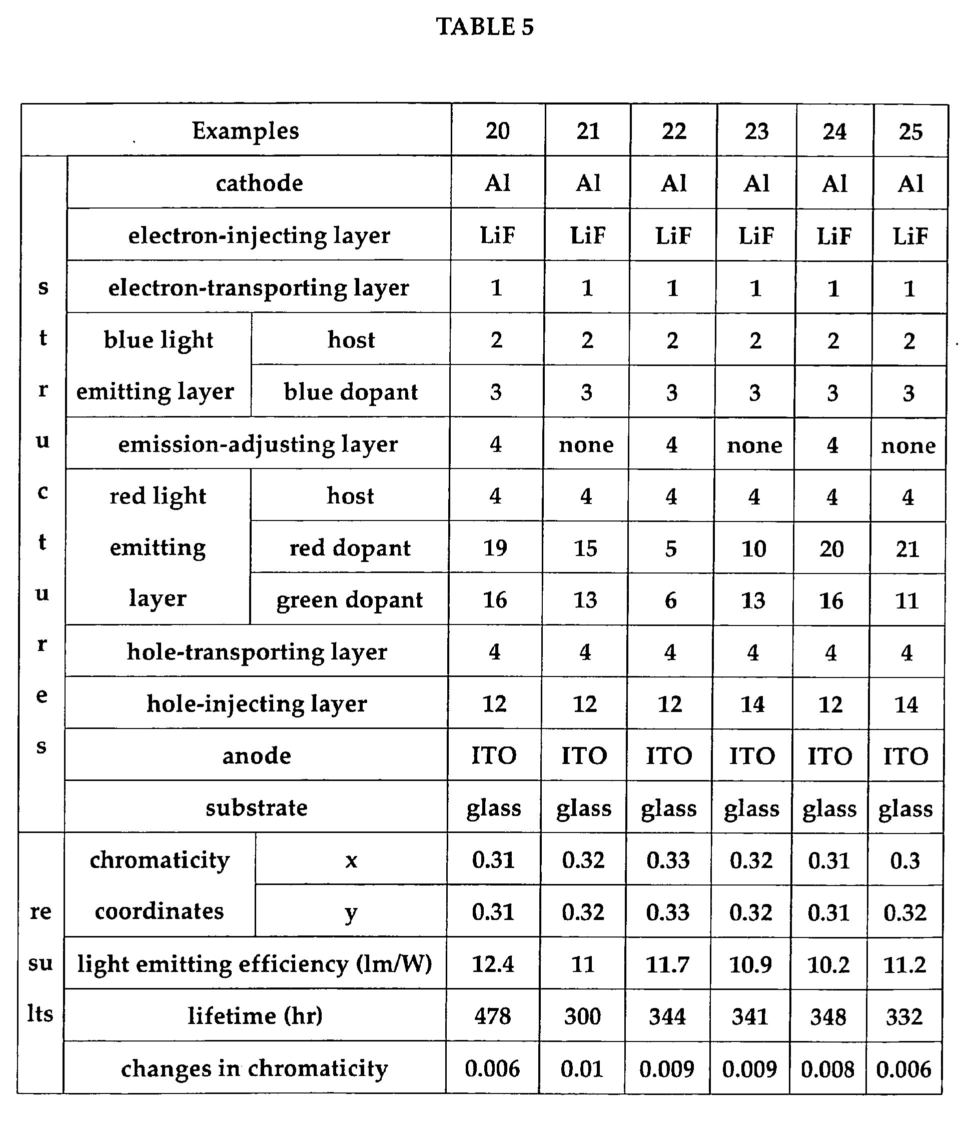

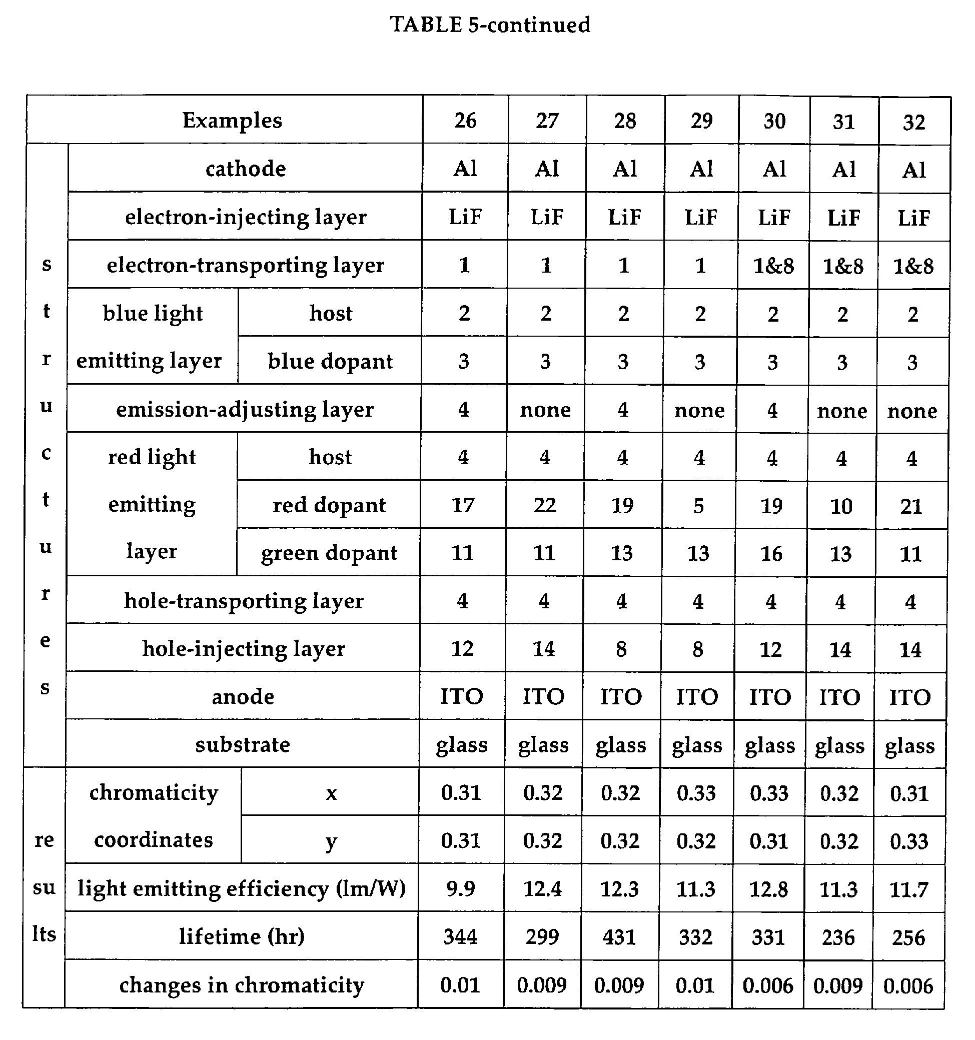

### < Comparative Examples 2-5 >

Comparative examples were prepared similarly to in the examples except that the lamination order of red and blue light-emitting layers was different from the present organic EL devices. The abbreviation numbers of the compounds in Table 6 are common with those in Tables 4 and 5.

Similarly to in the examples, of the organic EL devices of the comparative examples, chromaticity coordinates of lights emitted, light-emitting efficiency (lm/W) at the brightness of 1,600 cd/m², half-life of the initial brightness set at 4,800 cd/m² under a continuous current which was a time in which the brightness decreased from 4,800 cd/m² till 2,400 cd/m², and changes in chromaticity were measured. The brightness was measured by trade name BM7, Topcon K.K. The changes in chromaticity were defined as the square root of (variation in chromaticity x)² + (variation in chromaticity y)². Further, variation in chromaticity is a difference between the initial chromaticity and the chromaticity upon the brightness having been half decreased. The results obtained etc. are shown in Table 6.

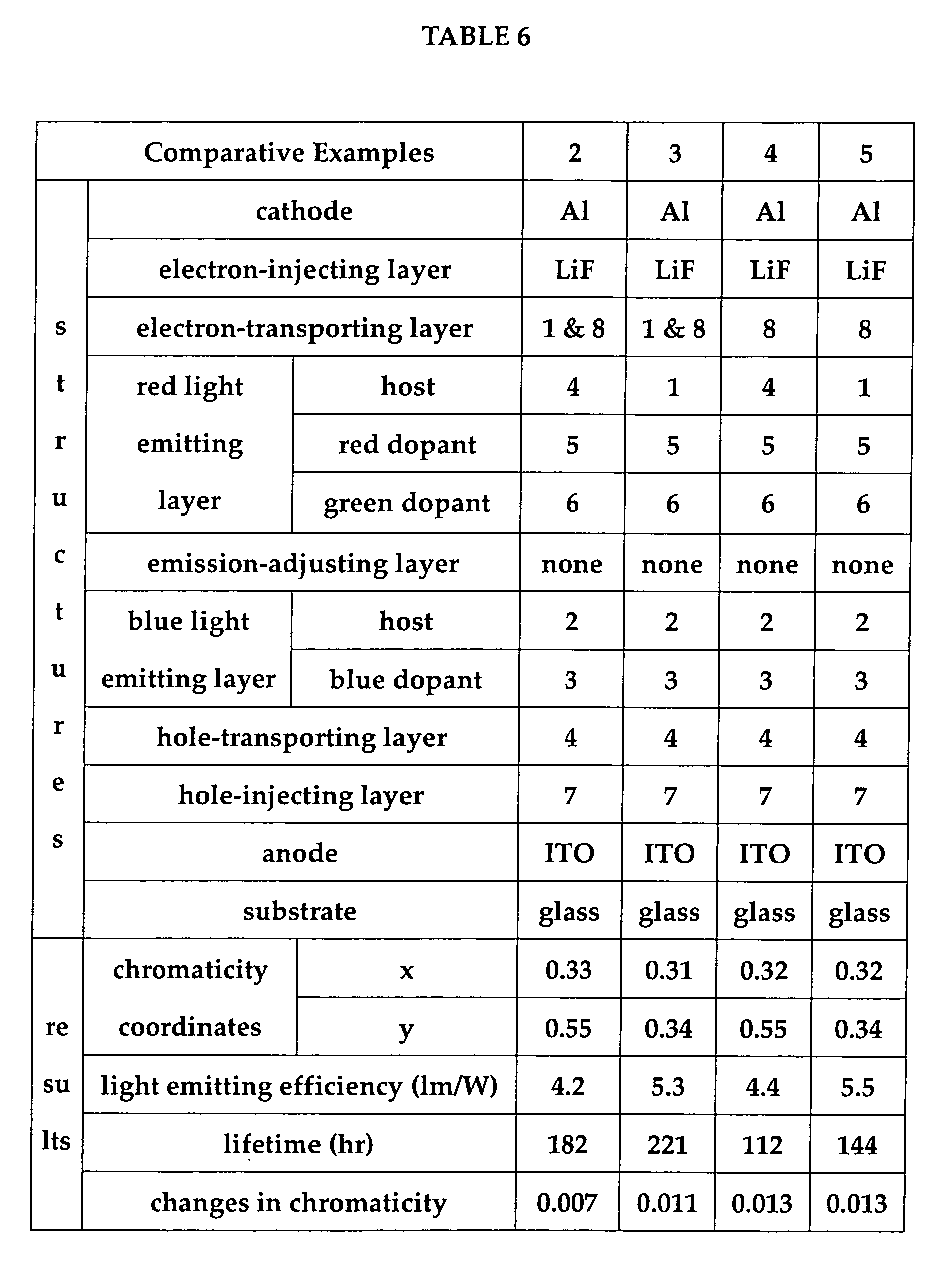

As can be seen from Tables 4-6, the chromaticity coordinates of the lights emitted from all the examples indicated superior whiteness. In the comparative examples, by contrast, their chromaticity coordinates, especially their y values, were large thus not giving good whiteness.

Compared to the comparative examples, the examples showed greatly improved light-emitting efficiency and lifetime.

Accordingly, in the examples, lamination of a red light-emitting layer containing a red light-emitting dopant and a green light-emitting dopant and a blue light-emitting layer containing a blue dopant in this order from the anode side gave superior whiteness and simultaneously high light-emitting efficiency and long lifetime.

## Claims

1. An organic EL device, having on its anode at least a light-emitting layer, an electron-injecting-transporting layer, and a cathode in this order, **characterized in that** a non-light-emitting layer having an electron-transporting property and having a higher hole-transporting property than said electron-injecting-transporting layer has is laminated between said electron-injecting-transporting layer and said light-emitting layer.

2. The organic EL device of claim 1 **characterized in that** the non-light-emitting layer has an electron-transporting property higher than a hole-transporting property.

3. The organic EL device of claim 1 or 2 **characterized in that** the non-light-emitting layer contains a material having an electron-transporting property and a higher hole-transporting property than the electron-injecting-transporting layer has.

4. The organic EL device of claim 1 or 2 **characterized in that** the non-light-emitting layer contains one or more electron-transporting material(s) having an electron-transporting property and one or more hole-transporting material(s) having a higher hole-transporting property than the electron-injecting-transporting layer has.

5. The organic EL device of claim 4 **characterized in that** at least one of the electron-transporting materials is/are the same as at least one of materials contained in the electron-injecting-transporting layer.

6. The organic EL device of claim 4 or 5 **characterized in that** at least one of the hole-transporting materials is/are the same as at least one of materials contained in the light-emitting layer.

7. The organic EL device of any one of claims 4-6 **characterized in that** the electron-transporting material has an electron-transporting property higher than the hole-transporting property of the hole-transporting material.

8. The organic EL device of any one of claims 1-7 **characterized in that** the hole-transporting property of the light-emitting layer is higher than the electron-transporting property of the light-emitting layer.

9. An organic EL device, having on its anode at least an organic light-emitting layer and then a cathode in this order, **characterized in that** said organic light-emitting layer consists of a lamination of a red light-emitting layer, containing at least one green light-emitting dopant(s), and of a blue light-emitting layer in this order from said anode side.

10. The organic EL device of claim 9 **characterized in that** the light-emitting spectrum has local maximum points in ranges of 440 nm-490 nm, of 510 nm-550 nm, and of 580 nm-680 nm.

11. The organic EL device of claim 9 or 10 **characterized in that** an emission-adjusting layer is laminated between the red light-emitting layer and the blue light-emitting layer.

12. The organic EL device of any one of claims 9-11 **characterized in that** the blue light-emitting layer is thicker than the red light-emitting layer.

13. The organic EL device of any one of claims 9-12 **characterized in that** the red light-emitting layer contains at least one red light-emitting dopant(s).

14. The organic EL device of any one of claims 9-13 **characterized in that** the hole-mobility of the red light-emitting layer is greater than that of the blue light-emitting layer.

15. The organic EL device of any one of claims 9-14 **characterized in that** the blue light-emitting layer contains at least one blue dopant(s) selected from the group consisting of pyrenes, perilenes, anthracenes, benzoxazoles, distyrylamine derivatives, benzothiazoles, benzimidazoles, chrysenes, phenanthrenes, distyrylbenzenes, and tetraarylbutadienes and at least one bipolar host(s) selected from the group consisting of stilbenes, carbazole derivatives, distyrylarylenes, triarylamines, aluminum bis(2-methyl-8-quinolinolate)(p-phenylphenolate), and 4,4'-bis(2,2-diarylvinyl)biphenyls.

16. The organic EL device of any one of claims 9-15 **characterized in that** the green light-emitting dopant(s) is/are at least one selected from the group consisting of coumarin derivatives and quinacridone derivatives.

17. A color display having the organic EL device of any one of claims 1-16 and at least one filter(s) absorbing part of the spectrum of lights emitted from the organic EL device.

18. A color display of claim 17 wherein the organic EL device has a light-emitting region within the transmission region of the filter.
